(19) Europäisches Patentamt
European Patent Office
Office européen des brevets

(11) **EP 4 528 341 A1**

(12) **EUROPEAN PATENT APPLICATION**

(43) Date of publication:
**26.03.2025 Bulletin 2025/13**

(21) Application number: **24200564.3**

(22) Date of filing: **16.09.2024**

(51) International Patent Classification (IPC):
**G02B 1/14** *(2015.01)* **G02B 1/11** *(2015.01)*
**G02B 1/18** *(2015.01)* **G06F 1/16** *(2006.01)*
**H10K 77/10** *(2023.01)*

(52) Cooperative Patent Classification (CPC):
**G02B 1/14; G02B 1/11; G02B 1/18; G06F 1/1652;
H10K 77/10**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **19.09.2023 KR 20230124496**

(71) Applicant: **Samsung Display Co., Ltd.
Gyeonggi-do 17113 (KR)**

(72) Inventors:
 • **Lee, Hee Young
 Yongin-si, Gyeonggi-do (KR)**

 • **Park, Gil Yeong
 Yongin-si, Gyeonggi-do (KR)**
 • **Han, So Yeon
 Yongin-si, Gyeonggi-do (KR)**
 • **Park, Sang Il
 Yongin-si, Gyeonggi-do (KR)**
 • **An, Sung Guk
 Yongin-si, Gyeonggi-do (KR)**

(74) Representative: **Gulde & Partner
Patent- und Rechtsanwaltskanzlei mbB
Berliner Freiheit 2
10785 Berlin (DE)**

(54) **DISPLAY DEVICE**

(57) A display device is provided. The display device includes a display panel, a cover window on the display panel, and an optical film on the cover window, wherein the optical film includes a base layer, a hard coating layer on the base layer, a low refraction layer on the hard coating layer, and an anti-fingerprint layer on the low refraction layer, and the optical film has a hardness of 35 Hv or more and has a crack strain of 2% or more.

**FIG. 10**

LRL: PR, PCP

EP 4 528 341 A1

**Description**

**BACKGROUND**

**1. Field**

Embodiments of the present disclosure relate to a display device.

**2. Description of the Related Art**

As the information society further develops, the use of display devices for displaying images has increased and diversified. For example, display devices have been applied to various electronic devices such as smartphones, digital cameras, laptop computers, navigation devices, and smart televisions.

The display devices may be flat panel display devices such as liquid crystal display devices, field emission display devices, and/or light emitting display devices. The light emitting display device includes an organic light emitting display device including organic light emitting elements, an inorganic light emitting display device including inorganic light emitting elements such as inorganic semiconductors, and/or a micro light emitting display device including micro light emitting elements.

The organic emitting element may include two electrodes opposing each other and a light emitting layer between the two electrodes. The light emitting layer receives electrons and holes from the two electrodes and recombines the electrons and the holes with each other to generate excitons, and may emit light while the generated excitons change from an excited state to a ground state.

Because the organic emitting display device including the organic light emitting elements does not require a light source such as a backlight unit, the organic emitting display device has low power consumption, may be configured to be lightweight and thin, and has high quality characteristics such as a wide viewing angle, high luminance and contrast, and a fast response speed, and accordingly, has attracted attention as the next-generation display device.

**SUMMARY**

Aspects of embodiments of the present disclosure provide a display device including an optical film capable of reducing reflectivity of external light and improving durability.

However, aspects of embodiments of the present disclosure are not restricted to those set forth herein. The above and other aspects of embodiments of the present disclosure will become more apparent to one of ordinary skill in the art to which the present disclosure pertains by referencing the detailed description of the present disclosure given below.

According to an aspect of embodiments of the present disclosure, a display device includes a display panel, a cover window on the display panel, and an optical film on the cover window, wherein the optical film includes a base layer, a hard coating layer on the base layer, a low refraction layer on the hard coating layer, and an anti-fingerprint layer on the low refraction layer, and the optical film has a hardness of 35 Hv or more and has a crack strain of 2% or more.

In an embodiment, the hard coating layer includes an acrylate-based compound and a urethane-based compound.

In an embodiment, a percentage of the acrylate-based compound is 70 to 99.9%, and a percentage of the urethane-based compound is 0.1 to 30%.

In an embodiment, the hard coating layer includes an acrylate-based compound.

In an embodiment, the hard coating layer has a thickness of 2 $\mu$m to 10 $\mu$m.

In an embodiment, the hard coating layer has a refractive index of 1.48 to 1.53.

In an embodiment, a refractive index of the low refraction layer is smaller than a refractive index of the hard coating layer by 0.05 or more.

In an embodiment, the refractive index of the low refraction layer is 1.3 to 1.43.

In an embodiment, the crack strain of the optical film is a crack strain of the optical film in a machine direction or a traverse direction. The machine direction is a length direction of the film and the traverse direction is a width direction of the film.

In an embodiment, the display device further includes a primer layer between the low refraction layer and the anti-fingerprint layer.

In an embodiment, the display device further includes a high refraction layer between the low refraction layer and the hard coating layer.

In an embodiment, a refractive index of the high refraction layer is greater than a refractive index of the low refraction layer by 0.05 or more.

In an embodiment, the refractive index of the high refraction layer is 1.53 to 1.7.

According to an aspect of embodiments of the present disclosure, a display device includes a display panel, a cover window on the display panel, and an optical film on the cover window, wherein the optical film includes a base layer, a hard coating layer on the base layer and including an acrylate-based compound, a low refraction layer on the hard coating layer, and an anti-fingerprint layer on the low refraction layer, and the optical film has a hardness of 35 Hv or more.

In an embodiment, the hard coating layer further includes a urethane-based compound, and a percentage of the acrylate-based compound is 70% or more.

In an embodiment, the hard coating layer has a thickness of 2 $\mu$m to 10 $\mu$m.

In an embodiment, the hard coating layer has a refractive index of 1.48 to 1.53.

In an embodiment, a refractive index of the low refraction layer is smaller than a refractive index of the hard coating layer by 0.05 or more.

In an embodiment, the refractive index of the low refraction layer is 1.3 to 1.43.

In an embodiment, a crack strain of the optical film in a traverse direction is 2% or more.

A display device according to an embodiment may reduce reflectivity of external light by including an optical film including a low refraction layer.

The display device according to embodiments may improve hardness and wear resistance characteristics of the optical film by including a hard coating layer.

The effects of embodiments of the present disclosure are not limited to the aforementioned effects, and various other effects are included in the present specification.

## BRIEF DESCRIPTION OF THE DRAWINGS

The above and other aspects and features of the present disclosure will become more apparent by describing in detail embodiments thereof with reference to the attached drawings, in which:

FIG. 1 is a schematic perspective view of an electronic device according to an embodiment;
FIG. 2 is a perspective view illustrating a folded state of a foldable display device according to an embodiment;
FIG. 3 is a perspective view illustrating an unfolded state of the foldable display device of FIG. 2;
FIG. 4 is a perspective view illustrating a display device included in the electronic device according to an embodiment;
FIG. 5 is a cross-sectional view of the display device of FIG. 4 viewed from the side;
FIG. 6 is a plan view illustrating a display layer of the display device according to an embodiment;
FIG. 7 is a plan view illustrating a touch sensing layer of the display device according to an embodiment;
FIG. 8 is a plan view illustrating an arrangement of emission areas in a display area of the display device according to an embodiment;
FIG. 9 is a cross-sectional view taken along line X-X' of FIG. 8;
FIG. 10 is a schematic cross-sectional view illustrating an optical film of the display device according to an embodiment;
FIG. 11 is a cross-sectional view illustrating destructive interference of external light in an embodiment of the optical film;
FIG. 12 is a cross-sectional view illustrating an optical film according to an embodiment;
FIG. 13 is a cross-sectional view illustrating an optical film according to an embodiment;
FIG. 14 is a cross-sectional view illustrating an optical film according to an embodiment;
FIG. 15 is a front black image of a display device manufactured according to Example 7;
FIG. 16 is a front black image of a display device manufactured according to #1 of Example 8; and
FIG. 17 is a front black image of a display device manufactured according to #1 of Example 9.

## DETAILED DESCRIPTION

The subject matter of the present disclosure will now be described more fully hereinafter with reference to the accompanying drawings, in which example embodiments of the disclosure are shown. The subject matter of this disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the spirit and scope of the present disclosure. Similarly, the second element could also be termed the first element.

Each of the features of the various embodiments of the present disclosure may be combined or combined with each other, in part or in whole, and technically various interlocking and driving are possible. Each embodiment may be implemented independently of each other or may be implemented together in an association.

Hereinafter, embodiments will be described with reference to the accompanying drawings.

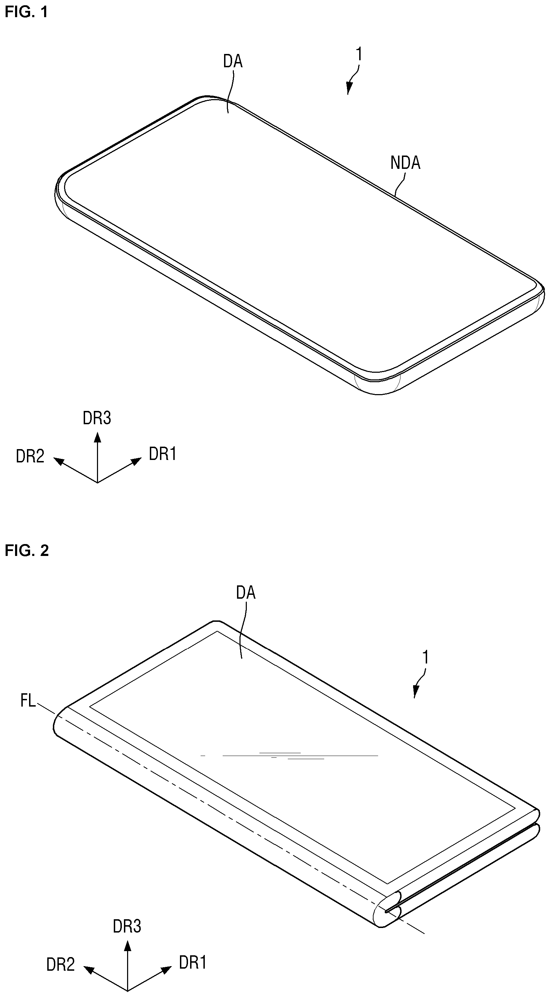

FIG. 1 is a schematic plan view of an electronic device according to an embodiment.

Referring to FIG. 1, an electronic device 1 displays a moving image and/or a still image. The electronic device 1 may refer to any suitable electronic devices that provide display screens. For example, televisions, laptop computers, monitors, billboards, the Internet of Things (IoT) devices, mobile phones, smartphones, tablet personal computers (PCs), electronic watches, smart watches, watch phones, head mounted displays, mobile communication terminals, electronic notebooks, electronic books, portable multimedia players (PMPs), navigation devices, game machines, digital cameras, camcorders, and/or the like, which provide display screens, may be included in the electronic device 1.

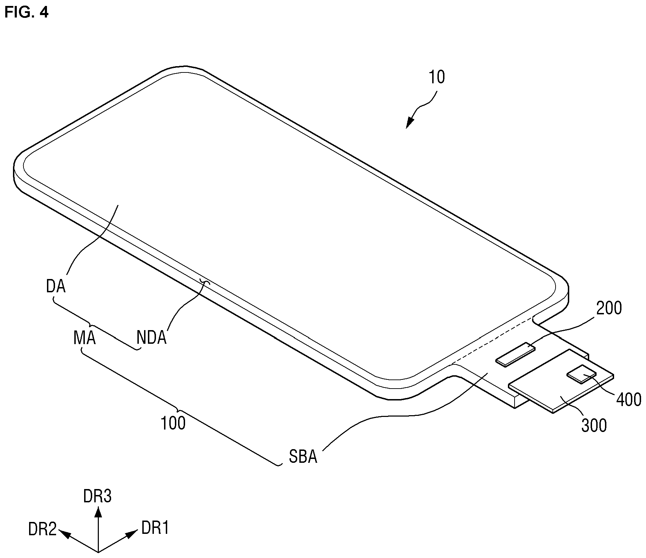

The electronic device 1 may include a display device 10 (see FIG. 4) that provides a display screen. Examples of the display device may include an inorganic light emitting diode display device, an organic light emitting display device, a quantum dot light emitting display device, a plasma display device, a field emission display device, and/or the like. Hereinafter, a case where an organic light emitting diode display device is applied as an example of the display device will be described by way of example, but the present disclosure is not limited thereto, and the same technical spirit may be applied to other display devices if applicable.

A shape of the electronic device 1 may be variously modified. For example, the electronic device 1 may have a shape such as a rectangular shape having a width greater than a length, a rectangular shape having a length greater than a width, a square shape, a quadrangular shape having rounded corners (vertices), other polygonal shapes, or a circular shape. A shape of a display area DA of the electronic device 1 may also be similar to an overall shape of the electronic device 1. In FIG. 1, the electronic device 1 having a rectangular shape having a greater length in a second direction DR2 has been illustrated.

The electronic device 1 may include a display area DA and a non-display area NDA. The display area DA is an area in which a screen may be displayed, and the non-display area NDA is an area in which the screen is not displayed. The display area DA may also be referred to as an active area, and the non-display area NDA may also be referred to as a non-active area. The display area DA may occupy substantially the center of the electronic device 1.

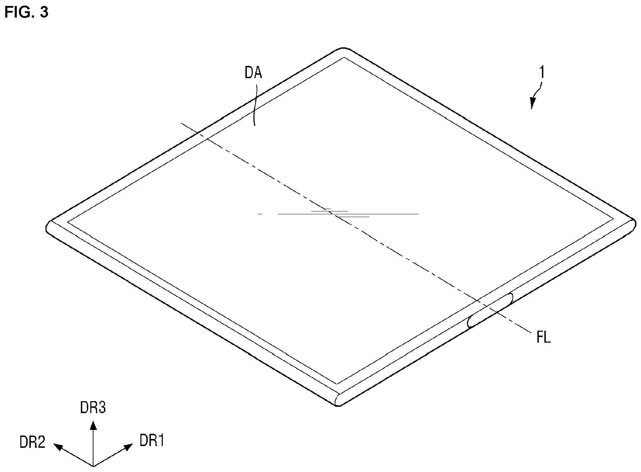

FIG. 2 is a perspective view illustrating a folded state of a foldable display device according to an embodiment. FIG. 3 is a perspective view illustrating an unfolded state of the foldable display device of FIG. 2.

Referring to FIGS. 2 and 3, the electronic device 1 according to an embodiment may be a foldable display device. The foldable electronic device 1 may be folded around a folding axis FL. A display area DA may be on an outer side and/or an inner side of the foldable electronic device 1. In an embodiment, it has been illustrated in FIGS. 2 and 3 that the display area DA is on each of the inner side and the outer side of the foldable electronic device 1.

The display area DA may be on the outer side of the electronic device 1. An outer side surface of the folded electronic device 1 may include the display area DA, and an inner side surface of the unfolded electronic device 1 may include the display area DA.

FIG. 4 is a perspective view illustrating a display device included in the electronic device according to an embodiment.

Referring to FIG. 4, the electronic device 1 according to an embodiment may include a display device 10. The display device 10 may provide a screen displayed by the electronic device 1. The display device 10 may have a shape similar to that of the electronic device 1 in a plan view. For example, the display device 10 may have a shape similar to a rectangular shape having short sides in a first direction DR1 and long sides in the second direction DR2. A corner where the short side in the first direction DR1 and the long side in the second direction DR2 meet may be rounded to have a curvature, but is not limited thereto, and may also form a right-angle. The shape of the display device 10 in a plan view is not limited to the rectangular shape, and may be a shape similar to other polygonal shapes, a circular shape, or an elliptical shape.

The display device 10 may include a display panel 100, a display driver 200, a circuit board 300, and a touch driver 400.

The display panel 100 may include a main area MA and a sub-area SBA.

The main area MA may include a display area DA including pixels that provide an image and a non-display area NDA provided around the display area DA. The display area DA may emit light from a plurality of emission areas or a plurality of opening areas. For example, the display panel 100 may include pixel circuits including switching elements, a pixel defining film defining the emission areas or the opening areas, and self-light emitting elements.

For example, the self-light emitting element may include at least one selected from an organic light emitting diode (LED) including an organic light emitting layer, a quantum dot LED including a quantum dot light emitting layer, an inorganic LED including an inorganic semiconductor, and a micro LED, but is not limited thereto.

The non-display area NDA may be an area outside the display area DA. The non-display area NDA may be defined as an edge area of the main area MA of the display panel 100. The non-display area NDA may include a gate driver supplying gate signals to gate lines, and fan-out lines connecting the display driver 200 and the display area DA to each other.

The sub-area SBA may be an area extending from one side of the main area MA. The sub-area SBA may include a flexible material that may be bent, folded, and/or rolled. For example, when the sub-area SBA is bent, the sub-area SBA may overlap the main area MA in a thickness direction (third direction DR3). The sub-area SBA may include the display driver 200 and pad parts connected to the circuit board 300. In an embodiment, the sub-area SBA may be omitted, and the display driver 200 and the pad parts may be provided in the non-display area NDA.

The display driver 200 may output signals and voltages for driving the display panel 100. The display driver 200 may supply data voltages to data lines. The display driver 200 may supply source voltages to power lines and supply gate control signals to the gate driver. The display driver 200 may be formed as an integrated circuit (IC) and mounted on the display panel 100 in a chip on glass (COG) manner, a chip on plastic (COP) manner, and/or an ultrasonic bonding manner. As an example, the display driver 200 may be provided in the sub-area SBA, and may overlap the main area MA in the thickness direction by bending of the sub-area SBA. As an example, the display driver 200 may be mounted on the circuit board 300.

The circuit board 300 may be attached onto the pad parts of the display panel 100 using an anisotropic conductive film (ACF). Lead lines of the circuit board 300 may be electrically connected to the pad parts of the display panel 100. The circuit board 300 may be a flexible printed circuit board, a printed circuit board, and/or a flexible film such as a chip on film.

The touch driver 400 may be mounted on the circuit board 300. The touch driver 400 may be connected to a touch sensing unit of the display panel 100. The touch driver 400 may supply touch driving signals to a plurality of touch electrodes of the touch sensing unit and sense change amounts in capacitance between the plurality of touch electrodes. For example, the touch driving signal may be a pulse signal having a set or predetermined frequency. The touch driver 400 may decide whether or not an input has occurred and calculate input coordinates, based on the change amounts in capacitance between the plurality of touch electrodes. The touch driver 400 may be formed as an integrated circuit (IC).

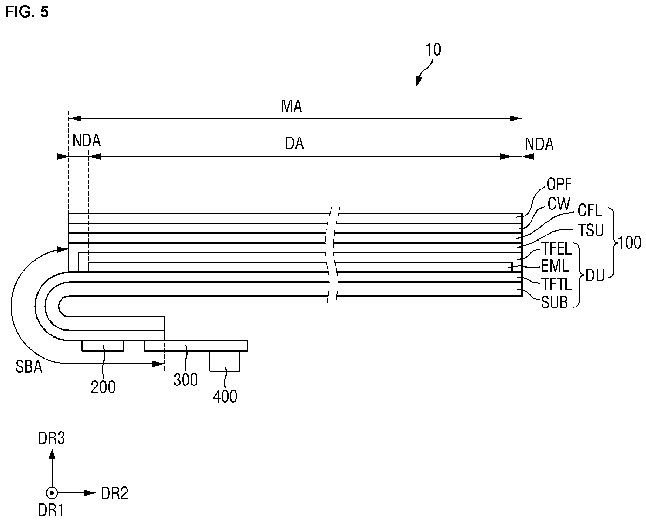

FIG. 5 is a cross-sectional view of the display device of FIG. 4 viewed from the side.

Referring to FIG. 5, the display device 10 may include a display layer DU, a touch sensing layer TSU, a color filter layer CFL, a cover window CW, and an optical film OPF. The display layer DU may include a substrate SUB, a thin film transistor layer TFTL, a light emitting element layer EML, and an encapsulation layer TFEL.

The substrate SUB may be a base substrate or a base member. The substrate SUB may be a flexible substrate that may be bent, folded, and/or rolled. For example, the substrate SUB may include a polymer resin such as polyimide (PI), but is not limited thereto. In an embodiment, the substrate SUB may include a glass material and/or a metal material.

The thin film transistor layer TFTL may be on the substrate SUB. The thin film transistor layer TFTL may include a plurality of thin film transistors constituting pixel circuits of pixels. The thin film transistor layer TFTL may further include gate lines, data lines, power lines, gate control lines, fan-out lines connecting the display driver 200 and the data lines to each other, and lead lines connecting the display driver 200 and the pad parts to each other. Each of the thin film transistors may include a semiconductor region, a source electrode, a drain electrode, and a gate electrode. For example, when a gate driver is on one side of the non-display area NDA of the display panel 100, the gate driver may include thin film transistors.

The thin film transistor layer TFTL may be provided in the display area DA, the non-display area NDA, and the sub-area SBA. The thin film transistors of each of the pixels, the gate lines, the data lines, and the power lines of the thin film transistor layer TFTL may be provided in the display area DA. The gate control lines and the fan-out lines of the thin film transistor layer TFTL may be provided in the non-display area NDA. The lead lines of the thin film transistor layer TFTL may be provided in the sub-area SBA.

The light emitting element layer EML may be on the thin film transistor layer TFTL. The light emitting element layer EML may include a plurality of light emitting elements each including a first electrode, a second electrode, and a light emitting layer to emit light and a pixel defining film defining the pixels. The plurality of light emitting elements of the light emitting element layer EML may be provided in the display area DA.

In an embodiment, the light emitting layer may be an organic light emitting layer including an organic material. The light emitting layer may include a hole transporting layer, an organic light emitting layer, and an electron transporting layer. When the first electrode receives a voltage through the thin film transistor of the thin film transistor layer TFTL and the second electrode receives a cathode voltage, holes and electrons may move to the organic light emitting layer through the hole transporting layer and the electron transporting layer, respectively, and may be combined with each other in the organic light emitting layer to emit light.

In an embodiment, the light emitting element may include a quantum dot light emitting diode including a quantum dot light emitting layer, an inorganic light emitting diode including an inorganic semiconductor, and/or a micro light emitting diode.

The encapsulation layer TFEL may cover an upper surface and side surfaces of the light emitting element layer EML, and may protect the light emitting element layer EML. The encapsulation layer TFEL may include at least one inorganic film and at least one organic film for encapsulating the light emitting element layer EML.

The touch sensing layer TSU may be on the encapsulation layer TFEL. The touch sensing layer TSU may include a plurality of touch electrodes for sensing a user's touch in a capacitance manner and touch lines connecting the plurality of touch electrodes and the touch driver 400 to each other. For example, the touch sensing layer TSU may sense the user's touch in a mutual capacitance manner or a self-capacitance manner.

In an embodiment, the touch sensing layer TSU may be on a separate substrate on the display layer DU. In some embodiments, the substrate supporting the touch sensing layer TSU may be a base member encapsulating the display layer DU.

The plurality of touch electrodes of the touch sensing layer TSU may be provided in a touch sensor area overlapping the display area DA. The touch lines of the touch sensing layer TSU may be provided in a touch peripheral area overlapping the non-display area NDA.

The color filter layer CFL may be on the touch sensing layer TSU. The color filter layer CFL may include a plurality of color filters each corresponding to the plurality of emission areas. Each of the color filters may selectively transmit light of a set or specific wavelength therethrough and block or reduce transmittance of and/or absorb light of other wavelengths. The color filter layer CFL may absorb some of light introduced from the outside of the display device 10 to reduce reflected light by external light. Accordingly, the color filter layer CFL may prevent or reduce distortion of colors due to external light reflection.

Because the color filter layer CFL is directly on the touch sensing layer TSU, the display device 10 may not require or use a separate substrate for the color filter layer CFL. Accordingly, a thickness of the display device 10 may be relatively small.

The cover window CW may be on the color filter layer CFL. The cover window CW may serve to protect the display panel 100. The cover window CW may be made of a transparent material. The cover window CW may include, for example, glass and/or plastic.

When the cover window CW includes the glass, the glass may be ultra thin glass (UTG) and/or thin glass. The ultra thin glass may be strengthened to have a set or predetermined stress profile therein. The strengthened ultra thin glass is more resistant to the occurrence of cracks, propagation of the cracks, damage, and/or the like, due to external shock than before being strengthened. The ultra thin glass strengthened through a strengthening process may have various suitable stresses for each area.

When the glass is the ultra thin glass and/or the thin glass, the glass may have flexible characteristics to be bent, folded, and/or rolled. A thickness of the glass may be, for example, in the range of 10 $\mu$m to 300 $\mu$m, and, for example, glass having a thickness of 10 $\mu$m to 100 $\mu$m or about 50 $\mu$m may be applied. The glass of the cover window CW may include soda lime glass, alkali aluminosilicate glass, borosilicate glass, and/or lithium aluminosilicate glass. The glass of the cover window CW may include chemically strengthened and/or thermally strengthened glass in order to have high strength. Chemical strengthening may be achieved through an ion exchange treatment process in an alkali salt. The ion exchange treatment process may be performed twice or more. In some embodiments, the cover window CW may be formed by coating both surfaces of a polymer film with thin glass.

The optical film OPF may be on the cover window CW. The optical film OPF may protect the cover window CW, reduce reflection of external light, and prevent a fingerprint from remaining (or may reduce the occurrence of residual fingerprints). A further detailed description of the optical film OPF will be provided below.

In some embodiments, a barrier layer may be below the display panel 100, and a plate may be below the barrier layer.

The barrier layer may include a polymer film. The barrier layer may include, for example, polyimide (PI), polyethylene terephthalate (PET), polycarbonate (PC), polyethylene (PE), polypropylene (PP), polysulfone (PSF), polymethyl methacrylate (PMMA), triacetyl cellulose (TAC), a cycloolefin polymer (COP), and/or the like. The barrier layer may include a functional layer on at least one surface thereof. The functional layer may include, for example, a light absorbing layer. The light absorbing layer may include a light absorbing material such as a black pigment and/or dye. The light absorbing layer may be made of black ink, and may be formed on the polymer film by a coating and/or printing method.

The plate may be a support member for coupling the display device 10 to a case. The plate may include a material having rigidity. In an embodiment, the plate may be made of a metal alloy such as stainless steel (SUS) and/or a single metal. A plurality of openings having a slit shape may be provided in the plate so that the display device 10 may be folded around the folding axis.

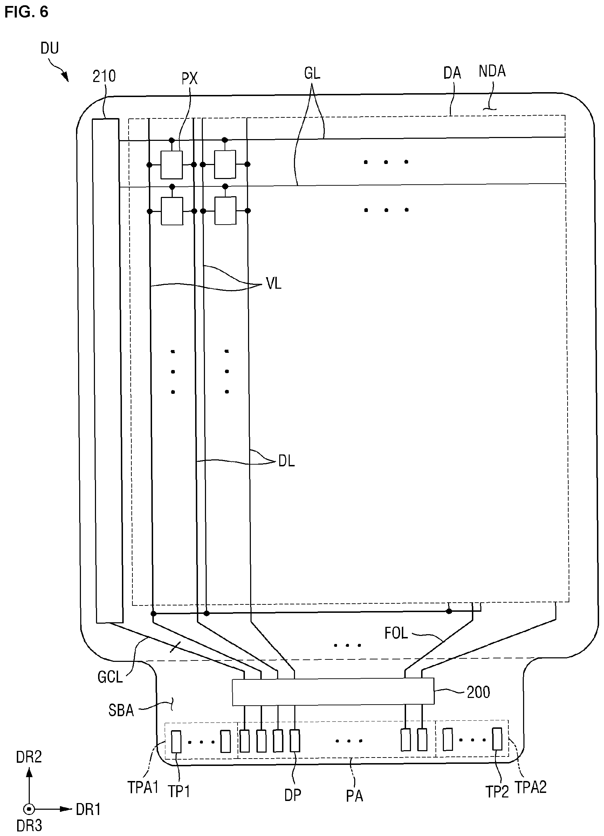

FIG. 6 is a plan view illustrating a display layer of the display device according to an embodiment.

Referring to FIG. 6, the display layer DU may include a display area DA and a non-display area NDA.

The display area DA may be provided at the center of the display panel 100. A plurality of pixels PX, a plurality of gate lines GL, a plurality of data lines DL, and a plurality of power lines VL may be provided in the display area DA. Each of the plurality of pixels PX may be defined as a minimum unit that emits light.

The plurality of gate lines GL may supply gate signals received from a gate driver 210 to the plurality of pixels PX. The plurality of gate lines GL may extend in the first direction DR1, and may be spaced apart from each other in the second direction DR2 crossing the first direction DR1.

The plurality of data lines DL may supply data voltages received from the display driver 200 to the plurality of pixels PX. The plurality of data lines DL may extend in the second direction DR2, and may be spaced apart from each other in the first direction DR1.

The plurality of power lines VL may supply source voltages received from the display driver 200 to the plurality of pixels PX. In some embodiments, the source voltage may be at least one selected from a driving voltage, an initialization voltage, a reference voltage, and a low potential voltage. The plurality of power lines VL may extend in the second direction DR2, and may be spaced apart from each other in the first direction DR1.

The non-display areas NDA may surround the display area DA. The gate driver 210, fan-out lines FOL, and gate control lines GCL may be provided in the non-display area NDA. The gate driver 210 may generate a plurality of gate signals based on gate control signals, and may sequentially supply the plurality of gate signals to the plurality of gate lines GL according to a set order.

The fan-out lines FOL may extend from the display driver 200 to the display area DA. The fan-out lines FOL may supply the data voltages received from the display driver 200 to the plurality of data lines DL.

The gate control lines GCL may extend from the display driver 200 to the gate driver 210. The gate control lines GCL may supply the gate control signals received from the display driver 200 to the gate driver 210.

The sub-area SBA may include the display driver 200, a pad area PA, and a first touch pad area TPA1 and a second touch pad area TPA2.

The display driver 200 may output signals and voltages for driving the display panel 100 to the fan-out lines FOL. The display driver 200 may supply the data voltages to the data lines DL through the fan-out lines FOL. The data voltages may be supplied to the plurality of pixels PX, and may control luminance of the plurality of pixels PX. The display driver 200 may supply the gate control signals to the gate driver 210 through the gate control lines GCL.

The pad area PA, the first touch pad area TPA1, and the second touch pad area TPA2 may be provided at an edge of the sub-area SBA. The pad area PA, the first touch pad area TPA1, and the second touch pad area TPA2 may be electrically connected to the circuit board 300 using a material such as an anisotropic conductive film and/or a self assembly anisotropic conductive paste (SAP).

The pad area PA may include a plurality of display pad parts DP. The plurality of display pad parts DP may be connected to a graphic system through the circuit board 300. The plurality of display pad parts DP may be connected to the circuit board 300 to receive digital video data, and may supply the digital video data to the display driver 200.

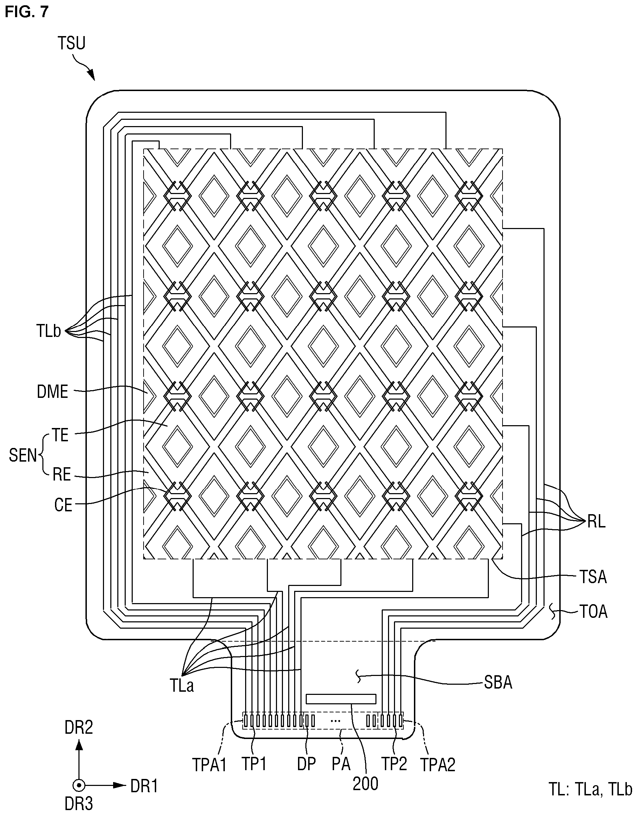

FIG. 7 is a plan view illustrating a touch sensing layer of the display device according to an embodiment.

Referring to FIG. 7, the touch sensing layer TSU may include a touch sensor area TSA that senses a user's touch and a touch peripheral area TOA provided around the touch sensor area TSA. The touch area TSA may be provided in the display area DA of the display device 10, and the touch peripheral area TOA may be provided in the non-display area NDA of the display device 10.

The touch sensor area TSA may include a plurality of touch electrodes SEN and a plurality of dummy electrodes DME. The plurality of touch electrodes SEN may form mutual capacitance or self-capacitance in order to sense a touch of an object and/or a person. The plurality of touch electrodes SEN may include a plurality of driving electrodes TE, a plurality of sensing electrodes RE, and bridge electrodes CE.

The plurality of driving electrodes TE may be arranged in the first direction DR1 and the second direction DR2. The plurality of driving electrodes TE may be spaced apart from each other in the first direction DR1 and the second direction DR2. The driving electrodes TE adjacent to each other in the second direction DR2 may be electrically connected to each other through the bridge electrode CE.

The plurality of driving electrodes TE may be connected to first touch pad parts TP1 through driving lines TL. The driving lines TL may include lower driving lines TLa and upper driving lines TLb. For example, the driving electrodes TE on the lower side of the touch sensor area TSA may be connected to the first touch pad parts TP1 through the lower driving lines TLa, and the driving electrodes TE on the upper side of the touch sensor area TSA may be connected to the first touch pad parts TP1 through the upper driving lines TLb. The lower driving lines TLa may extend to the first touch pad parts TP1 via the lower side of the touch peripheral area TOA. The upper driving lines TLb may extend to the first touch pad parts TP1 via the upper, left, and lower sides of the touch peripheral area TOA. The first touch pad parts TP1 may be connected to the touch driver 400 through the circuit board 300.

The bridge electrode CE may be bent at least once. For example, the bridge electrode CE may have a clamp shape ("<" or ">"), but a shape of the bridge electrode CE in a plan view is not limited thereto. The drive electrodes TE adjacent to each other in the second direction DR2 may be connected to each other by a plurality of bridge electrodes CE, and even though one of the bridge electrodes CE is disconnected, the driving electrodes TE may be stably connected to each other through the other bridge electrodes CE. The driving electrodes TE adjacent to each other may be connected to each other by two bridge electrodes CE, but the number of bridge electrodes CE is not limited thereto.

The bridge electrodes CE may be provided at a different layer from the plurality of driving electrodes TE and the plurality of sensing electrodes RE. The sensing electrodes RE adjacent to each other in the first direction DR1 may be electrically connected to each other through connection parts provided at the same layer as the plurality of driving electrodes TE or the plurality of sensing electrodes RE, and the driving electrodes TE adjacent to each other in the second direction DR2 may be electrically connected to each other through the bridge electrodes CE provided at a different layer as the plurality of driving electrodes TE or the plurality of sensing electrodes RE. Accordingly, even though the bridge electrodes CE overlap the plurality of sensing electrodes RE in a Z-axis direction, the plurality of driving electrodes TE and the plurality of sensing electrodes RE may be insulated (e.g., electrically insulated) from each other. Mutual capacitance may be formed between the driving electrodes TE and the sensing electrodes RE.

The plurality of sensing electrodes RE may extend in the first direction DR1 and may be spaced apart from each other in the second direction DR2. The plurality of sensing electrodes RE may be arranged in the first direction DR1 and the second direction DR2, and the plurality of sensing electrodes RE adjacent to each other in the first direction DR1 may be electrically connected to each other through the connection parts.

The plurality of sensing electrodes RE may be connected to second touch pad parts TP2 through sensing lines RL. For example, the sensing electrodes RE on the right side of the touch sensor area TSA may be connected to the second touch pad parts TP2 through the sensing lines RL. The sensing lines RL may extend to the second touch pad parts TP2 via the right side and the lower side of the touch peripheral area TOA. The second touch pad parts TP2 may be connected to the touch driver 400 through the circuit board 300.

Each of the plurality of dummy electrodes DME may be surrounded by the driving electrode TE or the sensing electrode RE. Each of the plurality of dummy electrodes DME may be spaced apart and insulated (e.g., electrically insulated) from the driving electrode TE or the sensing electrode RE. Accordingly, the dummy electrodes DME may be electrically floated.

The pad area PA, the first touch pad area TPA1, and the second touch pad area TPA2 may be provided at the edge of the sub-area SBA. The pad area PA, the first touch pad area TPA1, and the second touch pad area TPA2 may be electrically connected to the circuit board 300 using a low-resistance and high-reliability material such as an anisotropic conductive film and/or a self assembly anisotropic conductive paste (SAP).

The first touch pad area TPA1 may be on one side of the pad area PA, and may include a plurality of first touch pad parts TP1. The plurality of first touch pad parts TP1 may be electrically connected to the touch driver 400 on the circuit board 300. The plurality of first touch pad parts TP1 may supply touch driving signals to the plurality of driving electrodes TE through a plurality of driving lines TL.

The second touch pad area TPA2 may be on the other side of the pad area PA, and may include a plurality of second touch pad parts TP2. The plurality of second touch pad parts TP2 may be electrically connected to the touch driver 400 disposed on the circuit board 300. The touch driver 400 may receive touch sensing signals through a plurality of sensing lines RL connected to the plurality of second touch pad parts TP2, and may sense changes in mutual capacitance between the driving electrodes TE and the sensing electrodes RE.

In an embodiment, the touch driver 400 may supply a touch driving signal to each of the plurality of driving electrodes TE and the plurality of sensing electrodes RE, and may receive a touch sensing signal from each of the plurality of driving electrodes TE and the plurality of sensing electrodes RE. The touch driver 400 may sense a change amount in charge of each of the plurality of driving electrodes TE and the plurality of sensing electrodes RE based on the touch sensing signal.

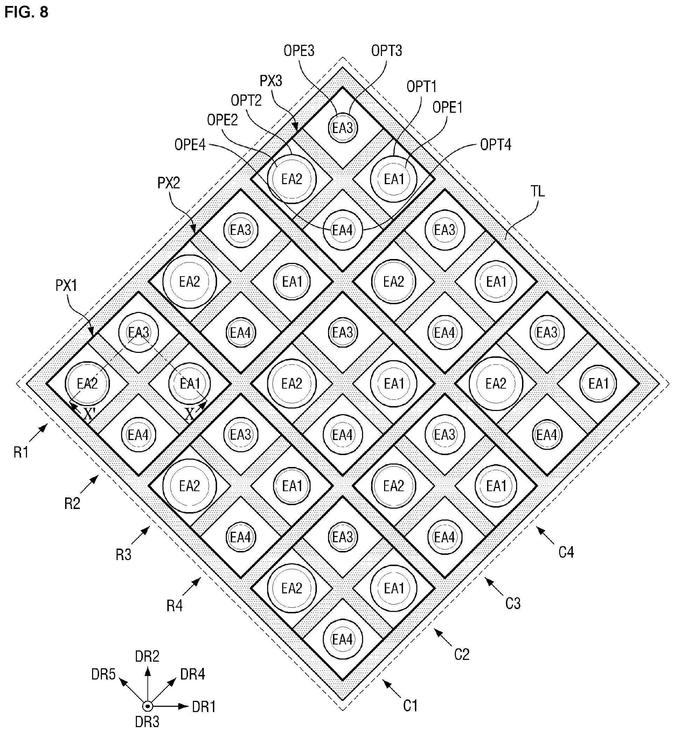

FIG. 8 is a plan view illustrating an arrangement of emission areas in a display area of the display device according to an embodiment.

Referring to FIG. 8, the display device 10 may include a plurality of pixels PX1, PX2, and PX3 provided in the display area DA and emission areas EA1, EA2, EA3, and EA4 and a non-emission area NEA provided in each of the pixels PX1, PX2, PX3, and PX4. The plurality of pixels PX1, PX2, and PX3 may be arranged in a fourth direction DR4 and a fifth direction DR5 between the first direction DR1 and the second direction DR2. First pixels PX1, second pixels PX2, and third pixels PX3 may be alternately arranged along the fourth direction DR4 and the fifth direction DR5. For example, the second pixels PX2 and the third pixels PX3 may be arranged along the fourth direction DR4 and the fifth direction DR5 based on the first pixel PX1. The plurality of pixels PX1, PX2, and PX3 may be in a PENTILEO arrangement structure (e.g., an RGBG matrix, RGBG structure, or RGBG matrix structure) or, for example, a DIAMOND PIXEL™ arrangement structure, in the display area DA. PENTILE® is a duly registered trademark of Samsung Display Co., Ltd. However, a layout or an arrangement of the pixels PX1, PX2, and PX3 is not limited to that illustrated in FIG. 8. In some embodiments, the plurality of pixels PX1, PX2, and PX3 may be arranged in a linear or island-shaped pattern.

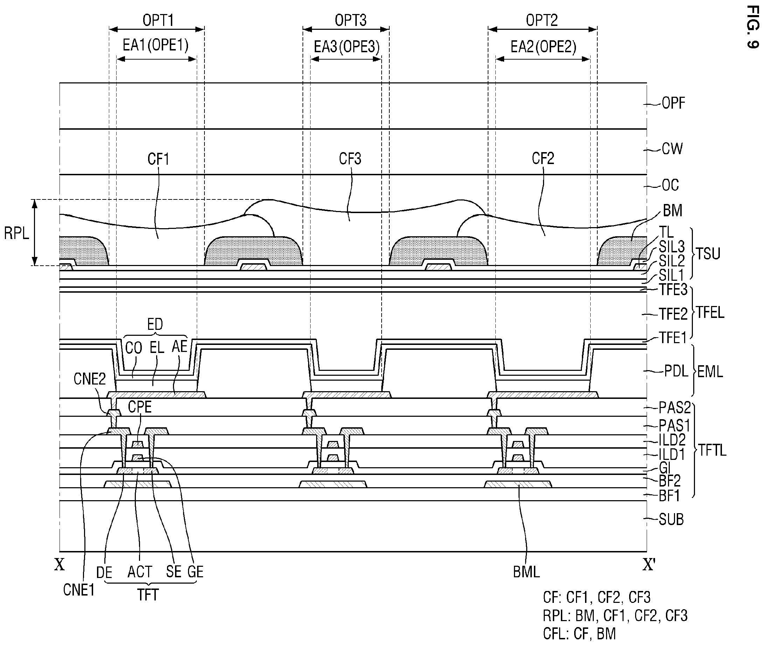

The emission areas EA1, EA2, EA3, and EA4 of each of the pixels PX1, PX2, and PX3 may include a first emission area EA1, a second emission area EA2, and a third emission area EA3 and a fourth emission area EA4 that emit light of different colors. Unlike the first emission area EA1 and the second emission area EA2, the third emission area EA3 and the fourth emission area EA4 may emit light of the same color. The first to fourth emission areas EA1, EA2, EA3, and EA4 may emit red, blue, or green light, respectively, and colors of the light emitted from the respective emission areas EA1, EA2, EA3, and EA4 may be different depending on a type (or kind) of light emitting element ED (see FIG. 9) provided in a light emitting element layer EML to be further described below. In an embodiment, the first emission area EA1 may emit a first light, which is the red light, the second emission area EA2 may emit a second light, which is the blue light, and the third emission area EA3 and the fourth emission area EA4 may each emit a third light, which is the green light. However, the present disclosure is not limited thereto.

A plurality of emission areas EA1, EA2, EA3, and EA4 may be provided in a PENTILE® arrangement structure (e.g., an RGBG matrix, RGBG structure, or RGBG matrix structure) or, for example, a DIAMOND PIXEL™ arrangement structure. PENTILE® is a duly registered trademark of Samsung Display Co., Ltd. For example, within each of the pixels PX1, PX2, and PX3, the first emission area EA1 and the second emission area EA2 may be spaced apart from each other in the first direction DR1, and the third emission area EA3 and the fourth emission area EA4 may be spaced apart from each other in the second direction DR2. The first emission area EA1 may be spaced apart from the third emission area EA3 in the fifth direction DR5, and may be spaced apart from the fourth emission area EA4 in the fourth direction DR4. The second emission area EA2 may be spaced apart from the third emission area EA3 in the fourth direction DR4, and may be spaced apart from the fourth emission area EA4 in the fifth direction DR5.

In the plurality of pixels PX1, PX2, and PX3, a plurality of first to fourth emission areas EA1, EA2, EA3, and EA4 may be alternately provided in the fourth direction DR4 or the fifth direction DR5. For example, the plurality of emission areas EA1, EA2, EA3, and EA4 may be provided in rows R1, R2, R3, and R4 arranged along the fourth direction DR4 and columns C1, C2, C3, and C4 arranged along the fifth direction DR5. The second emission areas EA2 and the third emission areas EA3 may be alternately provided along the fourth direction DR4 in a first row R1 and a third row R3. The first emission areas EA1 and the fourth emission areas EA4 may be alternately provided along the fourth direction DR4 in a second row R2 and a fourth row R4. The second emission areas EA2 and the fourth emission areas EA4 may be alternately provided along the fifth direction DR5 in a first column C1 and a third column C3. The first emission areas EA1 and the third emission areas EA3 may be alternately provided along the fourth direction DR4 in a second column C2 and a fourth column C4.

In some embodiments, the plurality of emission areas EA1, EA2, EA3, and EA4 may be arranged along the first direction DR1 or the second direction DR2. The first emission areas EA1 and the second emission areas EA2 may be alternately provided along the first direction DR1 and the second direction DR2. The third emission areas EA3 and the fourth emission areas EA4 may be alternately provided along the first direction DR1 and the second direction DR2.

The first to fourth emission areas EA1, EA2, EA3, and EA4 may be defined, respectively, by a plurality of openings OPE1, OPE2, OPE3, and OPE4 formed in a pixel defining film PDL (see FIG. 9) of a light emitting element layer EML to be further described below. For example, the first emission area EA1 may be defined by a first opening OPE1 of the pixel defining film, the second emission area EA2 may be defined by a second opening OPE2 of the pixel defining film, the third emission area EA3 may be defined by a third opening OPE3 of the pixel defining film, and the fourth emission area EA4 may be defined by a fourth opening OPE4 of the pixel defining film.

In an embodiment, areas or sizes of the first to fourth emission areas EA1, EA2, EA3, and EA4 may be different from each other. In an embodiment of FIG. 8, an area of the second emission area EA2 may be greater than areas of the first emission area EA1, the third emission area EA3, and the fourth emission area EA4, and an area of the first emission area EA1 may be greater than areas of the third emission area EA3 and the fourth emission area EA4. The areas of the emission areas EA1, EA2, EA3, and EA4 may change depending on sizes of the openings OPE1, OPE2, OPE3, and OPE4 formed in the pixel defining film. Intensities of the light emitted from the emission areas EA1, EA2, EA3, and EA4 may change depending on the areas of the emission areas EA1, EA2, EA3, and EA4, and a color feeling of a screen displayed on the display device 10 or the electronic device 1 may be controlled by adjusting the areas of the emission area EA1, EA2, EA3, and EA4. It has been illustrated in an embodiment of FIG. 8 that the second emission area EA2 has the greatest area, but the present disclosure is not limited thereto. The areas of the emission areas EA1, EA2, EA3, and EA4 may be freely adjusted according to a color feeling of the screen required or used by the display device 10 and the electronic device 1. In some embodiments, the areas of the emission areas EA1, EA2, EA3, and EA4 may be related to light efficiency, lifespan of light emitting elements ED, and/or the like, and may have a trade-off relationship with external light reflection. The areas of the emission areas EA1, EA2, EA3, and EA4 may be adjusted in consideration of the above and/or other factors.

It has been illustrated and described that each of the plurality of openings OPE1, OPE2, OPE3, and OPE4 and a plurality of holes OPT1, OPT2, OPT3, and OPT4 has a circular shape, but the present disclosure is not limited thereto, and each of the plurality of openings OPE1, OPE2, OPE3, and OPE4 and the plurality of holes OPT1, OPT2, OPT3, and OPT4 may have various suitable shapes such as an elliptical shape or polygonal shape of which edges are formed as curved lines.

Each of the plurality of pixels PX1, PX2, and PX3 may include the first to fourth emission areas EA1, EA2, EA3, and EA4 provided adjacent to each other to express a white gradation. However, the present disclosure is not limited thereto, and a combination of the emission areas EA1, EA2, EA3, and EA4 constituting one pixel group may be variously modified depending on an arrangement of the emission areas EA1, EA2, EA3, and EA4, colors of the light emitted by the emission areas EA1, EA2, EA3, and EA4, and/or the like.

The non-emission area NEA may be an area other than the emission areas EA1, EA2, EA3, and EA4. The non-emission area NEA may be between the emission areas EA1, EA2, EA3, and EA4. The non-emission area NEA may overlap the pixel defining film. For example, the non-emission area NEA may be the same as an area of the pixel defining film.

The display device 10 may include a plurality of color filters CF1 and CF2 and a color pattern CP on the emission areas EA1, EA2, EA3, and EA4. Each of the plurality of color filters CF1 and CF2 and the color pattern CP may to correspond to the emission areas EA1, EA2, EA3, and EA4. For example, the color filters CF1 and CF2 and the color pattern CP may overlap the emission areas EA1, EA2, EA3, and EA4, the openings OPE1, OPE2, OPE3, and OPE4, or the plurality of holes OPT1, OPT2, and OPT3, and OPT4. The plurality of holes OPT1, OPT2, OPT3, and OPT4 may overlap the openings OPE1, OPE2, OPE3, and OPE4, and may form light emitting areas through which the light emitted from the emission areas EA1, EA2, EA3, and EA4 is emitted. Each of the color filters CF1 and CF2 and the color pattern CP may have a greater area than each of the holes OPT1, OPT2, OPT3, and OPT4 and the openings OPE1, OPE2, OPE3, and OPE4, and may completely cover each of the light emitting areas formed by the holes OPT1, OPT2, OPT3, and OPT4.

The color filters CF1 and CF2 and the color pattern CP may each correspond to different emission areas EA1, EA2, EA3, and EA4. The color filters CF1 and CF2 may include a first color filter CF1 and a second color filter CF2. The color filters CF1 and CF2 and the color pattern CP may include colorants such as dyes and/or pigments that absorb light of wavelength bands other than light of a set or specific wavelength band, and may correspond to colors of the light emitting from the emission areas EA1, EA2, EA3, and EA4.

For example, the first color filter CF1 may be a red color filter provided to overlap the first emission area EA1 and transmit only the first light, which is the red light, therethrough. The second color filter CF2 may be a blue color filter provided to overlap the second emission area EA2 and transmit only the second light, which is the blue light, therethrough. The color pattern CP may be a green color filter provided to overlap the third emission area EA3 and the fourth emission area EA4 and transmit only the third light, which is the green light, therethrough.

The first color filter CF1 may overlap the first emission area EA1, but may be provided so as not to overlap the second emission area EA2, the third emission area EA3, and the fourth emission area EA4. The second color filter CF2 may overlap the second emission area EA2, but may be provided so as not to overlap the first emission area EA1, the third emission area EA3, and the fourth emission area EA4. The color pattern CP may be provided to overlap the third emission area EA3 and the fourth emission area EA4, but may be provided so as not to overlap the first emission area EA1 and the second emission area EA2. The color filters CF1 and CF2 and the color pattern CP may be provided to overlap the non-emission area NEA.

According to an embodiment, the plurality of color filters CF1 and CF2 and the color pattern CP may be provided to partially overlap other adjacent color filters CF1 and CF2 and color pattern CP. FIG. 8 illustrates an arrangement of the color filters CF1 and CF2 and the color pattern CP viewed from above, and the color filters CF1 and CF2 and the color patterns CP overlapping each other may overlap each other in the non-emission area NEA.

In the display device 10, the color filters CF1 and CF2 and the color pattern CP are provided to overlap each other, and accordingly, an intensity of reflected light by external light may be reduced. Furthermore, a color feeling of the reflected light by the external light may be controlled by adjusting an arrangement, shapes, areas, and/or the like, of the color filters CF1 and CF2 and the color pattern CP in a plan view.

A touch electrode TL may be between the emission areas EA1, EA2, EA3, and EA4. The touch electrode TL may extend in the fourth direction DR4 and the fifth direction DR5, may not overlap the emission areas EA1, EA2, EA3, and EA4, and may be spaced apart from the emission areas EA1, EA2, EA3, and EA4. The touch electrode TL may overlap a pixel defining film PDL (see FIG. 9) including the openings OPE1, OPE2, OPE3, and OPE4 and a light blocking layer BM (see FIG. 9) including a plurality of holes OPT1, OPT2, OPT3, and OPT4 to be further described below. Although the touch electrode TL has been briefly illustrated in FIG. 8, the touch electrode TL may be either the touch driving electrode TE or the sensing electrode RE of FIG. 7.

In some embodiments, diameters of the openings OPE1, OPE2, and OPE3 forming the emission areas EA1, EA2, EA3, and EA4 may be smaller than diameters of holes OPT1, OPT2, OPT3, and OPT4. The holes OPT1, OPT2, OPT3, and OPT4 may be defined between areas in which the first color filter CF1, the second color filter CF2, and the color pattern CP overlap each other. Opening intervals between the openings OPE1, OPE2, OPE3, and OPE4 and the holes OPT1, OPT2, OPT3, and OPT4 may be defined for each of the emission areas EA1, EA2, EA3, and EA4. The opening intervals may be defined as differences in diameter between the openings OPE1, OPE2, OPE3, and OPE4 of the pixel defining film PDL and the holes OPT1, OPT2, OPT3, and OPT4. In the display device 10, the opening intervals between the openings OPE1, OPE2, OPE3, and OPE4 and the holes OPT1, OPT2, OPT3, and OPT4 in the same emission areas EA1, EA2, EA3, and EA4 belonging to different pixels PX1, PX2, and PX3 may be different from each other. In the first pixel PX1, the second pixel PX2, and the third pixel PX3, the emission areas EA1, EA2, EA3, and EA4 emit light of the same color, but the opening intervals between the openings OPE1, OPE2, OPE3, and OPE4 and the holes OPT1, OPT2, OPT3, and OPT4 in the emission areas EA1, EA2, EA3, and EA4 may be different from each other.

For example, the first to third pixels PX1, PX2, and PX3 may include the first emission areas EA1 that emit the red light, respectively, but opening intervals of the first emission areas EA1 in the respective pixels PX1, PX2, and PX3 may be different from each other. In some embodiments, in the first to third pixels PX1, PX2, and PX3, the second to fourth emission areas EA2, EA3, and EA4 may also emit light of the same color, but opening intervals of the second to fourth emission areas EA2, EA3, and EA4 in the first to third pixels PX1, PX2, and PX3 may be different from each other. In some embodiments, within the respective pixels PX1, PX2, PX3, and PX4, opening intervals of the first to fourth emission areas EA1, EA2, EA3, and EA4 may be different from each other.

FIG. 9 is a cross-sectional view taken along line X-X' of FIG. 8. FIG. 9 illustrates a cross-section crossing the first emission area EA1, the third emission area EA3, and the second emission area EA2.

A cross-sectional structure of the display device 10 will now be described with reference to FIG 9 in addition to FIG. 8. The display panel 100 of the display device 10 may include a display layer DU, a touch sensing layer TSU, and a reflection reduction layer RPL. The display layer DU may include a substrate SUB, a thin film transistor layer TFTL, a light emitting element layer EML, and an encapsulation layer TFEL. The display panel 100 may include the reflection reduction layer RPL on the touch sensing layer TSU, and the reflection reduction layer RPL may include a light blocking layer BM and a color filter layer CFL.

The substrate SUB may be a base substrate and/or a base member. The substrate SUB may be a flexible substrate that may be bent, folded, and/or rolled. As an example, the substrate SUB may include a polymer resin such as polyimide (PI), but is not limited thereto. As another example, the substrate SUB may include a glass material and/or a metal material.

The thin film transistor layer TFTL may include a first buffer layer BF1, a bottom metal layer BML, a second buffer layer BF2, thin film transistors TFT, a gate insulating layer GI, a first interlayer insulating layer ILD1, capacitor electrodes CPE, a second interlayer insulating layer ILD2, first connection electrodes CNE1, a first passivation layer PAS1, second connection electrodes CNE2, and a second passivation layer PAS2.

The first buffer layer BF1 may be on the substrate SUB. The first buffer layer BF1 may include an inorganic film capable of preventing or reducing permeation of air and/or moisture. For example, the first buffer layer BF1 may include a plurality of inorganic films that are alternately stacked.

The bottom metal layer BML may be on the first buffer layer BF1. For example, the bottom metal layer BML may be formed as a single layer or a plurality of layers made of any one selected from molybdenum (Mo), aluminum (Al), chromium (Cr), gold (Au), titanium (Ti), nickel (Ni), neodymium (Nd), tantalum (Ta), and copper (Cu), and/or alloys thereof.

The second buffer layer BF2 may cover the first buffer layer BF1 and the bottom metal layer BML. The second buffer layer BF2 may include an inorganic film capable of preventing or reducing permeation of air and/or moisture. For example, the second buffer layer BF2 may include a plurality of inorganic films that are alternately stacked.

The thin film transistor TFT may be on the second buffer layer BF2, and may constitute a pixel circuit of each of the plurality of pixels. For example, the thin film transistor TFT may be a driving transistor or a switching transistor of the pixel circuit. The thin film transistor TFT may include a semiconductor layer ACT, a source electrode SE, a drain electrode DE, and a gate electrode GE.

The semiconductor layer ACT may be on the second buffer layer BF2. The semiconductor layer ACT may overlap the bottom metal layer BML and the gate electrode GE in the thickness direction, and may be insulated (e.g., electrically insulated from the gate electrode GE by the gate insulating layer GI. A material of the semiconductor layer ACT in portions of the semiconductor layer ACT may become conductors (e.g., electrical conductors) to form the source electrode SE and the drain electrode DE.

The gate electrode GE may be on the gate insulating layer GI. The gate electrode GE may overlap the semiconductor layer ACT with the gate insulating layer GI interposed therebetween.

The gate insulating layer GI may be on the semiconductor layer ACT. For example, the gate insulating layer GI may cover the semiconductor layer ACT and the second buffer layer BF2, and may insulate (e.g., electrically insulate) the semiconductor layer ACT and the gate electrode GE from each other. The gate insulating layer GI may include contact holes through which the first connection electrodes CNE1 penetrate.

The first interlayer insulating layer ILD1 may cover the gate electrode GE and the gate insulating layer GI. The first interlayer insulating layer ILD1 may include contact holes through which the first connection electrodes CNE1 penetrate. The contact holes of the first interlayer insulating layer ILD1 may be connected to the contact holes of the gate insulating layer GI and contact holes of the second interlayer insulating layer ILD2.

The capacitor electrodes CPE may be on the first interlayer insulating layer ILD1. The capacitor electrode CPE may overlap the gate electrode GE in the thickness direction. The capacitor electrode CPE and the gate electrode GE may form capacitance.

The second interlayer insulating layer ILD2 may cover the capacitor electrodes CPE and the first interlayer insulating layer ILD1. The second interlayer insulating layer ILD2 may include contact holes through which the first connection electrodes CNE1 penetrate. The contact holes of the second interlayer insulating layer ILD2 may be connected to the contact holes of the first interlayer insulating layer ILD1 and the contact holes of the gate insulating layer GI.

The first connection electrodes CNE1 may be on the second interlayer insulating layer ILD2. The first connection electrode CNE1 may electrically connect the drain electrode DE of the thin film transistor TFT and the second connection electrode CNE2 to each other. The first connection electrode CNE1 may be inserted into the contact holes formed in the second interlayer insulating layer ILD2, the first interlayer insulating layer ILD1, and the gate insulating layer GI to be in contact with the drain electrode DE of the thin film transistor TFT.

The first passivation layer PAS1 may cover the first connection electrode CNE1 and the second interlayer insulating layer ILD2. The first passivation layer PAS1 may protect the thin film transistor TFT. The first passivation layer PAS1 may include contact holes through which the second connection electrodes CNE2 penetrate.

The second connection electrodes CNE2 may be on the first passivation layer PAS1. The second connection electrode CNE2 may electrically connect the first connection electrode CNE1 and a pixel electrode AE of a light emitting element ED to each other. The second connection electrode CNE2 may be inserted into the contact hole formed in the first passivation layer PAS1 to be in contact with the first connection electrode CNE1.

The second passivation layer PAS2 may cover the second connection electrodes CNE2 and the first passivation layer PAS1. The second passivation layer PAS2 may include contact holes through which the pixel electrodes AE of the light emitting elements ED penetrate.

The light emitting element layer EML may be on the thin film transistor layer TFTL. The light emitting element layer EML may include light emitting elements ED and a pixel defining film PDL. The light emitting element ED may include the pixel electrode AE, a light emitting layer EL, and a common electrode CO.

The pixel electrode AE may be on the second passivation layer PAS2. The pixel electrode AE may be disposed to overlap any one of the openings OPE1, OPE2, OPE3, and OPE4 of the pixel defining film PDL. The pixel electrode AE may be electrically connected to the drain electrode DE of the thin film transistor TFT through the first and second connection electrodes CNE1 and CNE2.

The light emitting layer EL may be on the pixel electrode AE. For example, the light emitting layer EL may be an organic light emitting layer made of an organic material, but is not limited thereto. In embodiments where the light emitting layer EL is the organic light emitting layer, when the thin film transistor TFT applies a set or predetermined voltage to the pixel electrode AE of the light emitting element ED and the common electrode CO of the light emitting element ED receives a common voltage or a cathode voltage, holes and electrons may move to the light emitting layer EL through a hole transporting layer and an electron transporting layer, respectively, and may be combined with each other in the light emitting layer EL to emit light.

The common electrode CO may be on the light emitting layer EL. For example, the common electrode CO is not divided for each of the plurality of pixels, and may be implemented in the form of an electrode common to all the pixels. The common electrode CO may be on the light emitting layers EL in the first to fourth emission areas EA1, EA2, EA3, and EA4, and may be on the pixel defining film PDL in an area other than the first to fourth emission areas EA1, EA2, EA3, and EA4.

The common electrode CO may receive the common voltage or a low potential voltage. When the pixel electrode AE receives a voltage corresponding to a data voltage and the common electrode CO receives the low potential voltage, a potential difference is formed between the pixel electrode AE and the common electrode CO, such that the light emitting layer EL may emit light.

The pixel defining film PDL may include the plurality of openings OPE1, OPE2, OPE3, and OPE4 and may be on the second passivation layer PAS2 and portions of the pixel electrodes AE. The pixel defining film PDL may include the first opening OPE1, the second opening OPE2, the third opening OPE3, and the fourth opening OPE4, and the respective openings OPE1, OPE2, OPE3, and OPE4 may expose portions of the pixel electrode AE. As described above, the openings OPE1, OPE2, OPE3, and OPE4 of the pixel defining film PDL may define the first to fourth emission areas EA1, EA2, EA3, and EA4, respectively, and may have different areas or sizes. The pixel defining film PDL may space and insulate (e.g., electrically insulate) the pixel electrodes AE of a plurality of light emitting elements ED from each other. The pixel defining film PDL may include a light absorbing material to prevent or reduce light reflection. For example, the pixel defining film PDL may include a polyimide (PI)-based binder and a pigment in which red, green, and blue are mixed with each other. In some embodiments, the pixel defining film PDL may include a cardo-based binder resin and a mixture of a lactam black pigment and a blue pigment. In some embodiments, the pixel defining film PDL may include carbon black.

The encapsulation layer TFEL may be on the common electrodes CO to cover the plurality of light emitting elements ED. The encapsulation layer TFEL may include at least one inorganic film to prevent or reduce permeation of oxygen and/or moisture into the light emitting element layer EML. The encapsulation layer TFE may include at least one organic film to protect the light emitting element layer EML from foreign substances such as dust.

In an embodiment, the encapsulation layer TFEL may include a first encapsulation layer TFE1, a second encapsulation layer TFE2, and a third encapsulation layer TFE3. The first encapsulation layer TFE1 and the third encapsulation layer TFE3 may be inorganic encapsulation layers, and the second encapsulation layer TFE2 between the first encapsulation layer TFE1 and the third encapsulation layer TFE3 may be an organic encapsulation layer.

Each of the first encapsulation layer TFE1 and the third encapsulation layer TFE3 may include one or more inorganic insulating materials (e.g., inorganic electrically insulating materials). The inorganic insulating material may include aluminum oxide, titanium oxide, tantalum oxide, hafnium oxide, zinc oxide, silicon oxide, silicon nitride, and/or silicon oxynitride.

The second encapsulation layer TFE2 may include a polymer-based material. The polymer-based material may include an acrylic resin, an epoxy-based resin, polyimide, polyethylene, and/or the like. For example, the second encapsulation layer TFE2 may include an acrylic resin such as polymethyl methacrylate and/or polyacrylic acid. The second encapsulation layer TFE2 may be formed by curing a monomer and/or applying a polymer.

The touch sensing layer TSU may be on the encapsulation layer TFEL. The touch sensing layer TSU may include a first touch insulating layer SIL1, a second touch insulating layer SIL2, touch electrodes TL, and a third touch insulating layer SIL3.

The first touch insulating layer SIL1 may be on the encapsulation layer TFEL. The first touch insulating layer SIL1 may have insulating (e.g., electrically insulating) and optical functions. The first touch insulating layer SIL1 may include at least one inorganic film and/or organic film. Optionally, the first touch insulating layer SIL1 may be omitted.

The second touch insulating layer SIL2 may cover the first touch insulating layer SIL1. In some embodiments, touch electrodes of another layer may be further on the first touch insulating layer SIL1, and the second touch insulating layer SIL2 may cover such touch electrodes TL. The second touch insulating layer SIL2 may have insulating and optical functions. For example, the second touch insulating layer SIL2 may be an inorganic film including at least one selected from a silicon nitride layer, a silicon oxynitride layer, a silicon oxide layer, a titanium oxide layer, and an aluminum oxide layer and/or an organic film.

Some of the touch electrodes TL may be on the second touch insulating layer SIL2. Each of the touch electrodes TL may not overlap the first to fourth emission areas EA1, EA2, EA3, and EA4. Each of the touch electrodes TL may be formed as a single layer made of molybdenum (Mo), titanium (Ti), copper (Cu), tantalum (Ta), aluminum (Al), and/or indium tin oxide (ITO) or be formed as a stacked structure (Ti/Al/Ti) of aluminum and titanium, a stacked structure (ITO/Al/ITO) of aluminum and ITO, an APC alloy, and/or a stacked structure (ITO/APC/ITO) of an APC alloy and ITO.

The third touch insulating layer SIL3 may cover the touch electrodes TL and the second touch insulating layer SIL2. The third touch insulating layer SIL3 may have insulating (e.g., electrically insulating) and optical functions. The third touch insulating layer SIL3 may be made of the material exemplified in the second touch insulating layer SIL2.

The reflection reduction layer RPL may be on the touch sensing layer TSU. The reflection reduction layer RPL may include the light blocking layer BM and the color filter layer CFL. The display device 10 according to an embodiment includes the reflection reduction layer RPL implemented by the light blocking layer BM and the color filter layer CFL, such that a polarizing layer attached onto the display layer DU through a separate bonding member such as a pressure sensitive adhesive (PSA) or an optical clear adhesive (OCA) may be omitted.

The light blocking layer BM may be on the third touch insulating layer SIL3 of the touch sensing layer TSU. The light blocking layer BM may cover conductive lines of the touch electrodes TL, and may include the plurality of holes OPT1, OPT2, OPT3, and OPT4 provided to overlap the emission areas EA1, EA2, EA3, and EA4. For example, a first hole OPT1 may be provided to overlap the first emission area EA1 or the first opening OPE1. A second hole OPT2 may be provided to overlap the second emission area EA2 or the second opening OPE2, and a third hole OPT3 may be provided to overlap the third emission area EA3 or the third opening OPE3. In some embodiments, a fourth hole OPT4 may be provided to overlap the fourth emission area EA4 or the fourth opening OPE4. Areas or sizes of the respective holes OPT1, OPT2, OPT3, and OPT4 may be greater than areas or sizes of the openings OPE1, OPE2, OPE3, and OPE4 of the pixel defining film PDL. The holes OPT1, OPT2, OPT3, and OPT4 of the light blocking layer BM are formed to be greater than the openings OPE1, OPE2, OPE3, and OPE4 of the pixel defining film PDL, and accordingly, the light emitted from the emission areas EA1, EA2, EA3, and EA4 may be viewed by a user not only from a front surface of the display device 10 but also from side surfaces of the display device 10.

The light blocking layer BM may include a light absorbing material. For example, the light blocking layer BM may include an inorganic black pigment and/or an organic black pigment. The inorganic black pigment may be carbon black, and the organic black pigment may include at least one selected from lactam black, perylene black, and aniline black, but the present disclosure is not limited thereto. The light blocking layer BM may prevent or reduce color mixing due to permeation of visible light between the first to fourth emission areas EA1, EA2, EA3, and EA4 to improve a color gamut of the display device 10.

The color filters CF1, CF2, CF3, and CF4 of the color filter layer CFL may be on the light blocking layer BM. Different color filters CF1, CF2, CF3, and CF4 may correspond to the different emission areas EA1, EA2, EA3, and EA4 or openings OPE1, OPE2, OPE3, and OPE4 and the holes OPT1, OPT2, OPT3, and OPT4 of the light blocking layer BM, respectively. For example, the first color filter CF1 may correspond to the first emission area EA1, the second color filter CF2 may correspond to the second emission area EA2, and the third color filter CF3 may correspond to the third emission area EA3. The first color filter CF1 may be provided in the first hole OPT1 of the light blocking layer BM, the second color filter CF2 may be provided in the second hole OPT2 of the light blocking layer BM, and the third color filter CF3 may be provided in the third hole OPT3 of the light blocking layer BM. In some embodiments, the fourth color filter CF4 may be provided in the fourth hole OPT4 of the light blocking layer BM so as to correspond to the fourth emission area EA4. Each of the color filters CF1, CF2, CF3, and CF4 may have a greater area than each of the holes OPT1, OPT2, OPT3, and OPT4 of the light blocking layer BM in a plan view, and portions of each of the color filters CF1, CF2, CF3, and CF4 may be directly on the light blocking layer BM.

A planarization layer OC may be on the color filters CF1, CF2, CF3, and CF4 to planarize upper ends of the color filters CF1, CF2, CF3, and CF4. The planarization layer OC may be a colorless light transmitting layer that does not have a color of a visible light band. For example, the planarization layer OC may include a colorless light transmitting organic material such as an acrylic resin.

According to an embodiment, the color filters CF1, CF2, CF3, and CF4 of the display device 10 may overlap other color filters CF1, CF2, CF3, and CF4 adjacent thereto on the light blocking layer BM. The color filters CF1, CF2, CF3, and CF4 on the light blocking layer BM may be provided so that two color filters CF1, CF2, CF3, and CF4 adjacent to each other completely cover the light blocking layer BM. The two color filters CF1, CF2, CF3, and CF4 adjacent to each other may partially overlap each other on the light blocking layer BM. Such overlap between the color filters CF1, CF2, CF3, and CF4 may reduce external light reflection due to the light blocking layer BM, and an overlap arrangement of the color filters CF1, CF2, CF3, and CF4 may be designed so as to further reduce the external light reflection.

For example, in the display device 10, the first color filter CF1 and the third color filter CF3 adjacent to each other may overlap each other on the light blocking layer BM, and the second color filter CF2 and the third color filter CF3 may also overlap each other on the light blocking layer BM. The first color filter CF1 and the fourth color filter CF4 adjacent to each other and the second color filter CF2 and the fourth color filter CF4 adjacent to each other may also overlap each other on the light blocking layer BM.

The light blocking layer BM may include a material that absorbs light, but some of the light incident from the outside may also be reflected by the light blocking layer BM. The color filters CF1, CF2, CF3, and CF4 provided in the holes OPT1, OPT2, OPT3, and OPT4 of the light blocking layer BM may be partially provided directly on the light blocking layer BM, and may completely cover the light blocking layer BM. The two different color filters CF1, CF2, CF3, and CF4 adjacent to each other may include different colorants and may overlap each other on the light blocking layer BM, and accordingly, external light reflection due to the light blocking layer BM may be reduced. However, transmissivity of the color filters CF1, CF2, CF3, and CF4 may change depending on materials constituting the color filters CF1, CF2, CF3, and CF4, and reflection by external light may be more effectively reduced according to the overlap order of the color filters CF1, CF2, CF3, and CF4.

Hereinafter, the optical film OPF provided in front of the cover window CW will be further described.

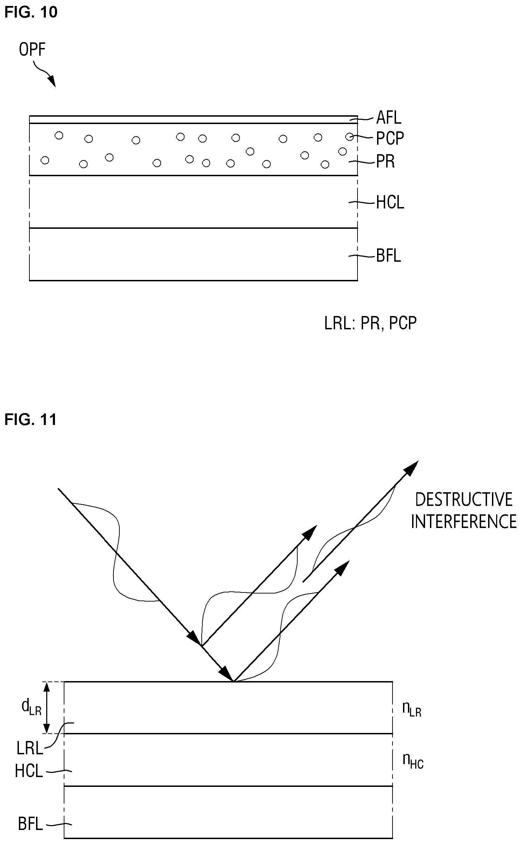

FIG. 10 is a schematic cross-sectional view illustrating an optical film of the display device according to an embodiment.

Referring to FIG. 10, the optical film OPF according to an embodiment may include a base layer BFL, a hard coating layer HCL on the base layer BFL, a low refraction layer LRL on the hard coat layer HCL, and an anti-fingerprint layer AFL on the low refraction layer LRL.

The base layer BFL may include a transparent polymer film. The transparent polymer film may include at least one selected from polyethylene terephthalate (PET), polyethylene naphthalate (PEN), polyether sulfone (PES), polyimide (PI), polyarylate (PAR), polycarbonate (PC), polymethyl methacrylate (PMMA), triacetyl cellulose (TAC), a cycloolefin copolymer (COC), and/or a polyether block amide (PEBA) resin. However, the present disclosure is not limited thereto.

In some embodiments, the base layer BFL is formed of a self-restoring composition including an elastomer resin based on any one selected from silicone, urethane, and urethane acrylate, such that urethane acrylate resins in the base layer BFL may have a ladder structure in which they may be supported by an aromatic group, a heteroaromatic group, or both of the aromatic group and the heteroaromatic group.

The aromatic urethane acrylate resin may be a urethane acrylate resin having an average number of functional groups of 2 to 5, and may be formed by a reaction of a polymerizable composition including an acrylate including a hydroxy group and an isocyanate compound. In some embodiments, at least one selected from the acrylate including the hydroxy group and the isocyanate compound may include an aromatic group, a heteroaromatic group, or both of the aromatic group and the heteroaromatic group, but is not limited thereto.

In an embodiment, the base layer BFL may have a single-layer structure. For example, the base layer BFL may be configured as one base layer (e.g., a single or sole base layer). However, the present disclosure is not limited thereto, and the base layer BFL may have a multilayer structure.

The base layer BFL may have a thickness of 50 $\mu$m to 200 $\mu$m. The base layer BFL may have suitable or sufficient bendability and self-restoring properties by having the thickness in the above thickness range, and may thus achieve uniform (or substantially uniform) performance.

The hard coating layer HCL may be on the base layer BFL. The hard coating layer HCL may reduce distortion and/or lifting phenomena of the optical film OPF under a harsh condition such as high temperature or high temperature and high humidity, and may thus improve a reliability problem.

The hard coating layer HCL may include an organic layer. The organic layer may include at least one selected from an acrylate-based compound, a urethane-based compound, polyimide, polycarbonate, polyethersulfone, polyethylene naphthalate, polyphenylene sulfide, a liquid crystal polymer (LCP), polymethyl methacrylate, and an epoxy-based polymer, or combinations thereof.

In an embodiment, the hard coating layer HCL may include an organic layer and an organic-inorganic composite layer. In this case, the organic layer may include an acrylate-based compound. For example, the organic layer may include urethane acrylate. The organic layer may be between the base layer BFL and the organic-inorganic composite layer to serve as a stress buffer layer.

An organic material in the organic-inorganic composite layer may be at least one selected from an acrylate-based compound, a polyurethane-based compound, and/or an epoxy-based compound, or combinations thereof. For example, the organic material may include urethane acrylate. An inorganic material in the organic-inorganic composite layer may be at least one selected from the group consisting of silicon oxide ($SiO_2$), zirconium oxide ($ZrO_2$), aluminum oxide ($Al_2O_3$), tantalum oxide ($Ta_2O_5$), niobium oxide ($Nb_2O_5$ and/or $NbOz$), and glass beads.

The inorganic material may be provided in the form of a single type (or kind) of inorganic oxide listed above or mixtures thereof. In some embodiments, the inorganic material may be provided in various suitable forms to form the organic-inorganic composite layer. For example, silicon oxide may be provided in the form of particles, sol, and/or a hollow shape.

In the organic-inorganic composite layer, the acrylate compound, which is the organic material, and inorganic particles may be mixed with each other and provided at a weight ratio of 5:5 to 8:2. The organic-inorganic composite layer may form the hard coating layer HCL that is not easily broken by including both the acrylate compound and the inorganic particles to have shock absorbency against external shock while improving surface hardness.

In an embodiment, the hard coating layer HCL may include an acrylate-based compound and a urethane-based compound. The acrylate-based compound and the urethane-based compound may be mixed with each other and polymerized from a monomer form. The acrylate-based compound may increase hardness and wear resistance of the optical film OPF by increasing hardness of the low refraction layer LRL. The urethane-based compound may increase elasticity of the optical film OPF by providing flexibility to the low refraction layer LRL. In some embodiments, a percentage of the acrylate-based compound in the hard coating layer HCL may be 70% to 99.9%, and a percentage of the urethane-based compound in the hard coating layer HCL may be 0.1 to 30%. For example, a mixing ratio of the acrylate-based compound and the urethane-based compound may be 7:3 or more, and a percentage of the acrylate-based compound may be further increased. For example, the percentage of the acrylate-based compound may be further increased in such a way that the mixing ratio of the acrylate-based compound and the urethane-based compound is 7:3, 8:2, or 9:1.

In an embodiment, the hard coating layer HCL may include an acrylate-based compound. In this case, the acrylate-based compound may be an acrylic resin. In some embodiments, the hard coating layer HCL may improve hardness and wear resistance of the optical film OPF by including the acrylic resin.

The hard coating layer HCL may have a thickness of 2 μm to 10 μm. The hard coating layer HCL may reduce the distortion and/or lifting phenomena by having the thickness in the above thickness range, and may thus improve the reliability problem.

The hard coating layer HCL may have a refractive index of 1.48 to 1.53. The hard coating layer HCL has a difference in refractive index at an interface between the hard coating layer HCL and a low refraction layer LRL to be further described below by having the refractive index in the above refractive index range, and may thus refract the light emitted from the light emitting element layer upward to increase emission efficiency and reduce reflection of external light.

The low refraction layer LRL may be on the hard coating layer HCL. The low refraction layer LRL may refract the light emitted from the light emitting element layer upward to increase emission efficiency and reduce reflection of external light.

The low refraction layer LRL may include particles PCP dispersed in a transparent resin PR.

The resin PR may include one or more selected from the group consisting of acryl, polysiloxane, polyurethane, polyurethane acrylate, polyimide, polymethylsilsesquioxane (PMSSQ), and polymethyl methacrylate (PMMA).

The particle PCP may be a particle that is a hollow. For example, the particle PCP may include one or more selected from the group consisting of silica ($SiO_2$), magnesium fluoride ($MgF_2$), and iron oxide ($Fe_3O_4$). In some embodiments, the particle PCP may include a shell made of one or more of the above materials and a hollow (e.g., a pore or pores) positioned inside the shell. In an embodiment, a diameter of the particle PCP may be 10 to 200 nm, and a thickness of the shell and a diameter of the hollow may be determined according to the diameter of the particle PCP.

The particles PCP included in the low refraction layer LRL may be included in a weight ratio of 10% to 50% with respect to the resin PR. When the weight ratio of the particles PCP to the resin PR is 10% or more, a refractive index of the low refraction layer LRL may be lowered, and when the weight ratio of the particles PCP to the resin PR is 50% or less, deterioration of adhesion to adjacent layers may be prevented or reduced. The low refraction layer LRL may be formed by coating and curing a solution including the resin PR and a solvent in which the particles PCP are dispersed.

The low refraction layer LRL may have a thickness of 10 to 200 nm. The low refraction layer LRL may decrease a refractive index and improve adhesion to a lower layer by having the thickness in the above thickness range to suitably or sufficiently include the particles PCP.

The refractive index of the low refraction layer LRL may be smaller than the refractive index of the hard coating layer HCL. For example, the refractive index of the low refraction layer LRL may be smaller than the refractive index of the hard coating layer HCL by 0.05 or more. When a difference between the refractive index of the low refraction layer LRL and the refractive index of the hard coating layer HCL is 0.05 or more, the total reflection of external light may be increased at the interface between the low refraction layer LRL and the hard coating layer HCL to induce destructive interference with light reflected from a surface of the low refraction layer LRL. Accordingly, reflectivity of external light of the optical film OPF may be reduced. The refractive index of the low refraction layer LRL may be in the range of 1.3 to 1.43. However, the present disclosure is not limited thereto, and a lower refractive index may be used as long as it is smaller than the refractive index of the hard coating layer HCL.

The anti-fingerprint layer AFL may be on the low refraction layer LRL. The optical film OPF may be exposed to the outside and be touched by a user's finger, and/or the like. For example, a surface of the optical film OPF may be used as a touch surface for a touch sensor. The anti-fingerprint layer AFL may prevent a user's fingerprint from remaining (or reduce an occurrence or amount of residual fingerprints) by including a water-repellent or oil-repellent material to improve contamination resistance.

The anti-fingerprint layer AFL may include an acrylate-based compound and a fluorine-based additive. As an example, the anti-fingerprint layer AFL may be a layer including a fluorine-containing silane compound in which a silane portion and a fluorinated carbon portion are connected to each other by an alkyl chain. As another example, the fluorine-based additive may include one selected from polytetra fluoroethylene (PTFE), polyvinylidene fluoride (PVDF), and amorphous fluorine (Teflon AF or Cytop).

The anti-fingerprint layer AFL may have a thickness of 5 nm to 30 nm. The anti-fingerprint layer AFL may maintain or improve anti-fingerprint characteristics by having the thickness in the above thickness range.

The display device 10 described above may perform folding and unfolding operations around the folding axis FL. When folding and unfolding of the display device 10 are repeated, a crack may occur in the optical film OPF. In an embodiment, a greater strain of a crack strain of the optical film OPF in a traverse direction TD and a crack strain of the optical film OPF in a machine direction MD may be 2% or more. For example, a crack strain of the optical film OPF in a machine direction MD may be 2% to 10%. The crack strain refers to a degree to which an object such as a film may withstand force when the force is applied in any one direction, and the greater the crack strain, the higher the resistance to forming a crack. The crack strain may be measured by a nano indenter. When the greater strain of the crack strain of the optical film OPF in the traverse direction TD and the crack strain of the optical film OPF in the machine direction MD is 2% or more, it is possible to suppress or reduce the occurrence of a crack in the optical film OPF due to a compressive strain generated by the folding and unfolding operations of the display device 10. The greater strain of the crack strain of the optical film OPF in the traverse direction TD and the crack strain of the optical film OPF in the machine direction MD may be, for example, 4% or more.

The optical film OPF may be provided at the uppermost portion of the display device 10 and be touched by a user's finger, a pen, and/or the like and/or directly exposed to external shock. In an embodiment, the hardness of the optical film OPF may be 35 Hv or more. When the hardness of the optical film OPF is 35 Hv or more, it is possible to reduce the occurrence of damage such as a crack from a user's finger, a pen, and/or an external shock.

In some embodiments, the display device 10 including the optical film OPF including the low refraction layer LRL and the hard coating layer HCL may have a reflectivity of 4.8% or less. Here, the reflectivity may be measured on an upper surface of the optical film OPF.

FIG. 11 is a cross-sectional view illustrating destructive interference of external light in the optical film.

Referring to FIG. 11, light reflected from the surface of the low refraction layer LRL and light reflected from the interface between the low refraction layer LRL and the hard coating layer HCL among external light incident on the low refraction layer LRL may destructively interfere with each other according to conditions of the following Equation.

Equation

$$d_{LR} = \lambda/4 \cdot n_{LR}$$

$$n_{LR} = \sqrt{n_{HC}}$$

In the above Equation, d indicates a thickness of the low refraction layer LRL, and n indicates a refractive index. $n_{LR}$ indicates a refractive index of the low refraction layer LRL, $n_{HC}$ indicates a refractive index of the hard coating layer HCL, and $d_{LR}$ indicates a thickness of the low refraction layer LRL.

According to an embodiment, the thickness of the low refraction layer LRL is 70 to 140 nm, the refractive index of the low refraction layer LRL is 1.38 to 1.42, and the refractive index of the hard coating layer HCL is 1.48 to 1.53. The low refraction layer LRL and hard coating layer HCL according to embodiments of the present disclosure may reduce the reflection of the external light by having the thickness and the refractive indices that satisfy the above Equation to induce destructive interference of external light.

Hereinafter, various embodiments of the optical film of the display device will be further described.

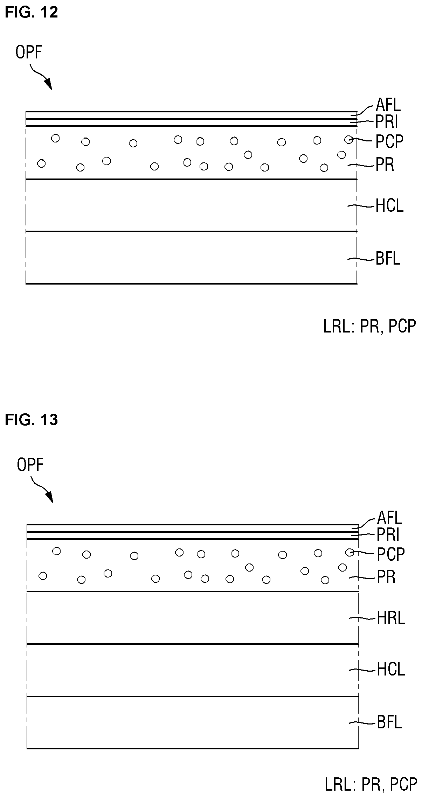

FIG. 12 is a cross-sectional view illustrating an optical film according to an embodiment.

Referring to FIG. 12, the present embodiment is different from the embodiment described above with reference to FIG. 10 in that the optical film OPF further includes a primer layer PRI. Hereinafter, a description of contents overlapping those of the above-described embodiment will not be repeated, and contents different from those of the above-described embodiment will be described.

The optical film OPF according to the present embodiment may include a base layer BFL, a hard coating layer HCL on the base layer BFL, a low refraction layer LRL on the hard coat layer HCL, the primer layer PRI on the low refraction layer LRL, and an anti-fingerprint layer AFL on the primer layer PRI.

The primer layer PRI may be between the low refraction layer LRL and the anti-fingerprint layer AFL. The primer layer PRI may function to improve a coupling force between the anti-fingerprint layer AFL and the low refraction layer LRL. The primer layer PRI may be formed through a primer treatment process. Primer treatment may improve adhesion between a polymer film and a resin by performing polymer treatment on the polymer film.

The primer layer PRI may include an acryl, ester, urethane, and/or siloxane-based polymer material. For example, the primer layer PRI may include a silane coupling agent and isocyanate.

The primer layer PRI may have a thickness 10 nm to 30 nm. The primer layer PRI may improve the coupling force between the anti-fingerprint layer AFL and the low refraction layer LRL in the above thickness range.

In the optical film OPF including the primer layer PRI, the coupling force between the low refraction layer LRL and the anti-fingerprint layer AFL may be improved to improve durability of the optical film OPF.

FIG. 13 is a cross-sectional view illustrating an optical film according to an embodiment.

Referring to FIG. 13, the present embodiment is different from the embodiment described above with reference to FIG. 10 in that the optical film OPF further includes a high refraction layer HRL.

The optical film OPF according to the present embodiment may include a base layer BFL, a hard coating layer HCL on the base layer BFL, the high refraction layer HRL on the hard coat layer HCL, a low refraction layer LRL on the high refraction layer HRL, and an anti-fingerprint layer AFL on the low refraction layer LRL.

The high refraction layer HRL may be between the hard coating layer HCL and the low refraction layer LRL. The high refraction layer HRL may be below the low refraction layer LRL and may function to induce destructive interference of external light at an interface between the high refraction layer HRL and the low refraction layer LRL to reduce reflectivity.

The high refraction layer HRL may include an inorganic material, an organic material, or an inorganic material and an organic material. Therefore, the high refraction layer HRL may be formed as an inorganic film, an organic film, or an organic film including inorganic particles.

The inorganic material included in the high refraction layer HRL may be one or more selected from the group consisting of zinc oxide, titanium oxide, zirconium oxide, niobium oxide, tantalum oxide, tin oxide, nickel oxide, silicon oxide, silicon nitride, indium nitride, and gallium nitride.

The organic material included in the high refraction layer HRL may be one or more selected from the group consisting of poly(3,4-ethylenedioxythiophene) (PEDOT), 4,4'-bis[N-(3-methylphenyl)-N-phenylamino]biphenyl (TPD), 4,4',4"-tris[(3-methylphenyl)phenyl aminotriphenylamine (m-MTDATA), 1,3,5-tris[N,N-bis(2-methylphenyl)-amino]-benzene (o-MTDAB), 1,3,5-tris[N,N-bis(3-methylphenyl)-amino]-benzene (m-MTDAB), 1,3,5-tris[N,N-bis(4-methylphenyl)-amino]-benzene (p-MTDAB), 4,4'-bis[N,N-bis(3-methylphenyl)-amino]-diphenylmethane (BPPM), 4,4'-dicarbazolyl-1,1'-biphenyl (CBP), 4,4',4"-tris(N-carbazole)triphenylamine (TCTA), 2,2',2"-(1,3,5-benzentolyl)tris-[1-phenyl-1H-benzoimidazole] (TPBI), and 3-(4-biphenyl)-4-phenyl-5-t-butylphenyl-1,2,4-triazole (TAZ).

A refractive index of the high refraction layer HRL may be greater than a refractive index of the low refraction layer LRL in order to reduce reflection of external light. For example, the refractive index of the high refraction layer HRL may be greater than the refractive index of the low refraction layer LRL by 0.05 or more. The refractive index of the high refraction layer HRL may be in the range of 1.53 to 1.7. However, the present disclosure is not limited thereto, and a greater refractive index may be used as long as it is greater than the refractive index of the low refraction layer LRL.

The high refraction layer HRL may have a thickness of 50 to 200 nm. The high refraction layer HRL has the thickness in the above thickness range, such that the interface between the high refraction layer HRL and the low refraction layer LRL may be formed to be flat (or substantially flat) and a decrease in coupling force between the high refraction layer HRL and the hard coating layer HCL may be prevented or reduced.

The optical film OPF further including the high refraction layer HRL may further reduce the reflection of the external light by increasing a difference in refractive index at the interface between the high refraction layer HRL and the low refraction layer LRL.

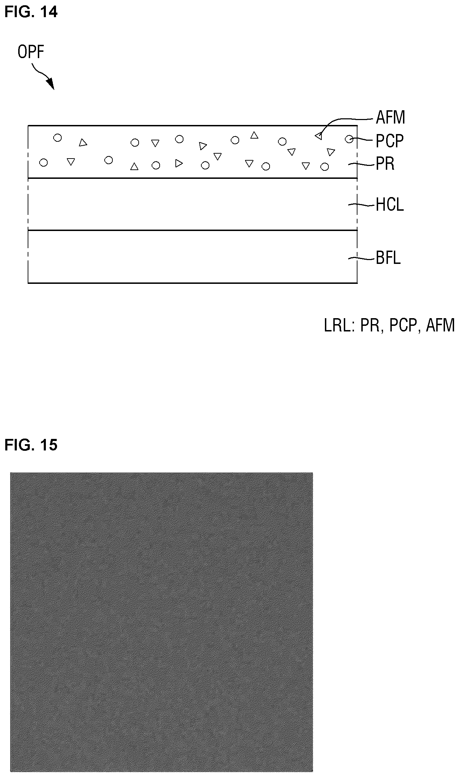

FIG. 14 is a cross-sectional view illustrating an optical film according to an embodiment.

Referring to FIG. 14, the present embodiment is different from the embodiment described above with reference to FIG. 10 in that a composite layer CPL is provided instead of the low refraction layer LRL and the anti-fingerprint layer AFL.

The optical film OPF according to the present embodiment may include a base layer BFL, a hard coating layer HCL on the base layer BFL, and the composite layer CPL on the hard coat layer HCL.

The composite layer CPL may be on the hard coating layer HCL. The composite layer CPL may compositely perform a function of the low refraction layer and a function of the anti-fingerprint layer. The composite layer CPL may be disposed at the uppermost portion of the optical film OPF and may reduce reflectivity of external light and prevent a user's fingerprint from remaining (or reduce an occurrence of residual fingerprints).

The composite layer CPL may include particles PCP and anti-fingerprint materials AFM that are dispersed in a transparent resin PR. The resin PR and the particles PCP have been described in detail in the description of the low refraction layer LRL, and a description thereof will thus not be repeated here. The composite layer CPL contains the anti-fingerprint materials AFM along with the materials of the low refraction layer, such that contamination resistance of the composite layer CPL may be improved.

The anti-fingerprint material AFM may be a fluorine-based additive. The fluorine-based additive may include one selected from polytetra fluoroethylene (PTFE), polyvinylidene fluoride (PVDF), and amorphous fluorine (Teflon AF and/or Cytop).

The composite layer CPL may have a thickness of 10 to 200 nm. The composite layer CPL may lower a refractive index and improve adhesion between the composite layer CPL and a lower layer by having the thickness in the above thickness range to suitably or sufficiently include the particles PCP, and may improve contamination resistance by including the anti-fingerprint materials AFM.

A refractive index of the composite layer CPL may be smaller than a refractive index of the hard coating layer HCL in order to reduce reflection of external light. For example, the refractive index of the composite layer CPL may be in the range of 1.3 to 1.48. However, the present disclosure is not limited thereto, and a lower refractive index may be used as long as it is smaller than the refractive index of the hard coating layer HCL.

The optical film OPF including the composite layer CPL may implement a thin display device 10 due to a decrease in thickness of the optical film OPF.

Hereinafter, Experimental Examples including Examples will be provided in order to assist in the understanding of the subject matter of the present disclosure. However, it should be apparent to one of ordinary skill in the art that such Examples are only examples of the present disclosure and do not limit the claims, and various suitable modifications and alterations may be made without departing from the scope and spirit of the present disclosure. In addition, these modifications and alterations will fall within the appended claims, and equivalents thereof.

**Manufacture Example 1: Manufacture of Optical Film**

A base layer was formed at a thickness of 65 $\mu$m by machine PET in one direction. A hard coating layer was formed by applying a urethane acrylic resin at a thickness of 5 $\mu$m onto the base layer, and a low refraction layer was formed at a thickness of 100 nm by mixing an acrylic resin and silica particles with each other on the hard coating layer. An optical film was manufactured by mixing an acrylic resin and polytetrafluoroethylene with each other on the low refraction layer to form an anti-fingerprint layer at a thickness of 20 nm.

**Example 1**

An optical film was manufactured by forming a hard coating layer in a ratio of an acrylate-based compound and a urethane-based compound of 7:3 in Manufacture Example 1.

**Example 2**

An optical film was manufactured under the same conditions as Example 1 except that the low refraction layer was omitted.

**Example 3**

An optical film was manufactured under the same conditions as Example 1 except that a high refraction layer was formed by applying PEDOT at a thickness of 100 nm between the low refraction layer and the hard coating layer.

**Experimental Example 1**

**Evaluation of Crack Strain of Optical Film Sample**

Crack strains, in a machine direction, a traverse direction, and a 45° direction, of the optical film manufactured according to Example 1, were measured and shown in Table 1. The crack strains were measured using a nano indenter.

Table 1

| | Crack Strain (%) | | |
|---|---|---|---|
| | TD | MD | 45° |
| Example 1 | 2 | 1 | 1.5 |

Referring to Table 1, the crack strain of the optical film according to Example 1 in the traverse direction was 2% or more, and the crack strain of the optical film according to Example 1 in the traverse direction was greater than the crack strain of the optical film according to Example 1 in the machine direction.

**Manufacture Example 2: Manufacture of Display Device of FIG. 5**

The display device illustrated in FIG. 5 was manufactured by attaching the optical film onto a display panel to which a cover window is attached. In this case, a barrier layer and a plate were also provided below the display panel.

**Example 4**

A display device was manufactured by attaching the optical film according to Example 1 so that the traverse direction of the optical film was perpendicular to the folding axis.

**Example 5**

A display device was manufactured by attaching the optical film according to Example 1 so that the traverse direction of the optical film was disposed at 45° with respect to the folding axis.

**Example 6**

A display device was manufactured by attaching the optical film according to Example 1 so that the machine direction of the optical film was perpendicular to the folding axis.

**Example 7**

A display device was manufactured by attaching the optical film according to Example 2.

**Example 8**

Display devices were manufactured by attaching the optical film according to Example 1. In this case, in #1, a refractive index of the low refraction layer of the optical film was 1.42, and in #2, a refractive index of the low refraction layer of the optical film was 1.40.

**Example 9**

Display devices were manufactured by attaching the optical film according to Example 3. In this case, in #1, a refractive index of the low refraction layer of the optical film was 1.42 and a refractive index of the high refraction layer of the optical film was 1.59, and in #2, a refractive index of the low refraction layer of the optical film was 1.40 and a refractive index of the high refraction layer of the optical film was 1.59.

**Experimental Example 2**

**Low-temperature Folding Test of Display Device**

The presence or absence of cracks in the optical films was observed while performing a folding test in which folding and unfolding were repeated 30,000 times at a low temperature of -20 °C on the display devices manufactured according to Examples 4 to 6, and a test result was shown in Table 2.

Table 2

|  | Low-temperature Folding Test Result |
|---|---|
| Example 4 | 30,000 times OK |
| Example 5 | 30,000 times OK |
| Example 6 | 1,000 times NG |

Referring to Table 2, in Examples 4 and 5, no cracks occurred in the optical films in the folding test performed 30,000 times. On the other hand, in Example 6, cracks occurred in the optical film in the folding test performed 1,000 times.
Through such a result, it was confirmed that the occurrence of cracks in the optical film might be suppressed or reduced by disposing a direction in which a crack strain of the optical film is 2% or more and the folding axis so as to cross each other.

## Experimental Example 3

## Measurement of Reflectivity of Display Device

Reflectivities of the display devices manufactured according to Examples 7 to 9 were measured and shown in Table 3. In addition, front black images of display devices manufactured according to Example 7, #1 of Example 8, and #1 of Example 9 are illustrated in FIGS. 15 to 17, respectively.

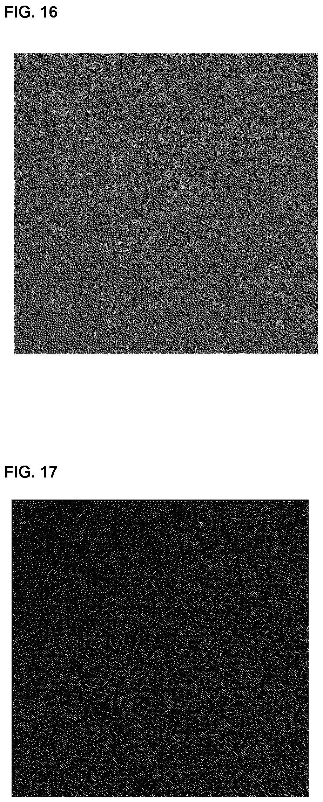

FIG. 15 is a front black image of a display device manufactured according to Example 7. FIG. 16 is a front black image of a display device manufactured according to #1 of Example 8. FIG. 17 is a front black image of a display device manufactured according to #1 of Example 9.
The reflectivities were shown in specular component included (SCI) and specular component excluded (SCE), respectively. The front black image of the display device was captured with an optical camera.

Table 3

|  |  | Example 7 | Example 8 | | Example 9 | |
|---|---|---|---|---|---|---|
|  |  |  | #1 | #2 | #1 | #2 |
| SCI | Reflectivity (%) | 6.3 | 4.2 | 3.8 | 2.9 | 2.6 |
|  | a*/b* | -1.2/-2.7 | -1.0/-2.8 | -0.3/-2.5 | -1.0/-6.9 | 1.0/-8.2 |
| SCE | Reflectivity (%) | 0.7 | 0.7 | 0.8 | 0.8 | 0.9 |
|  | a*/b* | -0.9/-4.4 | -1.2/-4.8 | -1.5/-4.9 | -0.8/-8.4 | -0.4/-10.9 |

Referring to Table 3, in the display device according to Example 7 that does not include the low refraction layer, a reflectivity of regular reflection light was 6.3. On the other hand, in the display devices according to Example 8 that include the low refraction layer, reflectivities of regular reflection light were 4.2 and 3.8, which were relatively low. In the display devices according to Example 9 that include the low refraction layer and the high reflectivity layer, reflectivities of regular reflection light were 2.9 and 2.6, which were relatively lower.
In addition, referring to FIGS. 15 to 17, a front black color feeling of the display device according to Example 8 was closer to black than that of the display device according to Example 7, and a front black color feeling of the display device according to Example 9 was closer to black than that of the display device according to Example 8.
Through such a result, it could be confirmed that the display device including the optical film including the low refraction layer or the low refraction layer and the high refraction layer might significantly reduce a reflectivity of external light.

## Manufacture Example 3: Manufacture of Test Substrate

A test substrate was manufactured by attaching the optical film according to Manufacture Example 1 onto a glass substrate using a pressure sensitive adhesive (PSA).

## Example 10

An optical film was manufactured by forming a hard coating layer in a ratio of an acrylate-based compound and a urethane-based compound of 5.5:4.5 in Manufacture Example 1. A test substrate was manufactured by attaching such an optical film according to Manufacture Example 3.

### Example 11

A test substrate was manufactured under the same conditions as Example 10 except that a hard coating layer was formed in a ratio of an acrylate-based compound and a urethane-based compound of 6:4.

### Example 12

A test substrate was manufactured under the same conditions as Example 10 except that a hard coating layer was formed in a ratio of an acrylate-based compound and a urethane-based compound of 6.5:3.5.

### Example 13

A test substrate was manufactured under the same conditions as Example 10 except that a hard coating layer was formed in a ratio of an acrylate-based compound and a urethane-based compound of 7:3.

### Example 14

A test substrate was manufactured under the same conditions as Example 10 except that a hard coating layer was formed in a ratio of an acrylate-based compound and a urethane-based compound of 8:2.

### Example 15

A test substrate was manufactured under the same conditions as Example 10 except that a hard coating layer was formed in a ratio of an acrylate-based compound and a urethane-based compound of 9:1.

### Example 16

A test substrate was manufactured under the same conditions as Example 10 except that a hard coating layer was formed of an acrylate-based compound.

### Experimental Example 4

### Evaluation of Hardness and Wear Resistance Characteristics of Optical Film

In the test substrates manufactured according to Examples 10 to 16, hardness and wear resistance characteristics of the optical films were evaluated and shown in Table 4.

The hardness of the optical film was measured using a nano indenter and measured at a depth of 0.5 $\mu$m.

The wear resistance characteristics were measured using a process of fixing an eraser of 3 cm to a jig so as to protrude from an end of the jig by 5 mm, bringing the eraser into contact with the test substrate with a load of 1 kg, and reciprocating a length of 15 mm once as one cycle. A contact angle was measured by dropping deionized (DI) water on a surface of the test substrate every 1,000 cycles, and cycles when the contact angle of the DI water was less than 95° were recorded.

Table 4

| | Example 10 | Example 11 | Example 12 | Example 13 | Example 14 | Example 15 | Example 16 |
|---|---|---|---|---|---|---|---|
| Hardness | 25 | 28 | 30 | 35 | 41 | 62 | 96 |
| Wear Resistance (Cycle) | 1,000 | 2,000 | 2,000 | 3,000 | 4,000 | 5,000 | 8,000 |

Referring to Table 4, in Examples 10, 11, and 12 in which a percentage of the acrylate-based compound in the hard coating layer was less than 70%, the hardness of the optical film was 30 or less and the wear resistance characteristics of the optical film were 2,000 cycles or less. On the other hand, in Examples 13 to 17 in which a percentage of the acrylate-based compound in the hard coating layer was 70% or more, the hardness of the optical film was 35 or more and the wear resistance characteristics of the optical film were 3,000 cycles or more.

Through such a result, it could be confirmed that when the percentage of the acrylate-based compound in the hard coating layer of the optical film was 70% or more, the hardness and the wear resistance characteristics of the optical film were improved. In particular, as the percentage of the acrylate-based compound was increased, the hardness and the wear resistance characteristics of the optical film were improved.

In concluding the detailed description, those skilled in the art will appreciate that many variations and modifications can be made to the disclosed embodiments without substantially departing from the principles of the present disclosure. Therefore, the disclosed embodiments of the present disclosure are used in a generic and descriptive sense only and not for purposes of limitation.

**Claims**

1. A display device comprising:

   a display panel (100);
   a cover window (CW) on the display panel (100); and
   an optical film (OPF) on the cover window,
   wherein the optical film (OPF) comprises:

   a base layer (BFL);
   a hard coating layer (HCL) on the base layer;
   a low refraction layer (LRL) on the hard coating layer; and
   an anti-fingerprint layer (AFL) on the low refraction layer, and
   the optical film has a hardness of 35 Hv or more and has a crack strain of 2% or more.

2. The display device of claim 1, wherein the hard coating layer comprises an acrylate-based compound and a urethane-based compound.

3. The display device of claim 1 or 2, wherein a percentage of the acrylate-based compound is 70% or more.

4. The display device of claim 3, wherein a percentage of the acrylate-based compound is 70 to 99.9%, and a percentage of the urethane-based compound is 0.1 to 30%.

5. The display device of any of the preceding claims, wherein the hard coating layer (HCL) comprises an acrylate-based compound.

6. The display device of any of the preceding claims, wherein the hard coating layer (HCL) has a thickness of 2 $\mu$m to 10 $\mu$m.

7. The display device of any of the preceding claims, wherein the hard coating layer (HCL) has a refractive index of 1.48 to 1.53.

8. The display device of any of the preceding claims, wherein a refractive index of the low refraction layer (LRL) is smaller than a refractive index of the hard coating layer by 0.05 or more.

9. The display device of claim 8, wherein the refractive index of the low refraction layer (LRL) is 1.3 to 1.43.

10. The display device of any of the preceding claims, wherein the crack strain of the optical film (OPF) is a crack strain of the optical film in a machine direction or a traverse direction.

11. The display device of any of the preceding claims, further comprising a primer layer (PRI) between the low refraction layer (OPF) and the anti-fingerprint layer (AFL).

12. The display device of any of the preceding claims, further comprising a high refraction layer (HRL) between the low refraction layer (LRL) and the hard coating layer (HCL).

13. The display device of claim 12, wherein a refractive index of the high refraction layer (HRL) is greater than a refractive index of the low refraction layer (LRL) by 0.05 or more.

14. The display device of claim 13, wherein the refractive index of the high refraction layer (HRL) is 1.53 to 1.7.

FIG. 1

DA

NDA

1

DR3

DR2 DR1

FIG. 2

DA

FL

1

DR3

DR2 DR1

**FIG. 3**

FIG. 4

FIG. 5

**FIG. 6**

**FIG. 7**

FIG. 8

FIG. 9

**FIG. 10**

OPF

AFL
PCP
PR
HCL
BFL

LRL: PR, PCP

**FIG. 11**

DESTRUCTIVE
INTERFERENCE

$d_{LR}$

$n_{LR}$

LRL
HCL

$n_{HC}$

BFL

FIG. 12

OPF

AFL
PRI
PCP
PR
HCL
BFL

LRL: PR, PCP

FIG. 13

OPF

AFL
PRI
PCP
PR
HRL
HCL
BFL

LRL: PR, PCP

**FIG. 14**

OPF

AFM
PCP
PR
HCL
BFL

LRL: PR, PCP, AFM

**FIG. 15**

FIG. 16

FIG. 17

Europäisches Patentamt
European Patent Office
Office européen des brevets

# EUROPEAN SEARCH REPORT

Application Number
EP 24 20 0564

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | JP 2021 004963 A (FUKUVI CHEM IND CO) 14 January 2021 (2021-01-14)<br>* paragraphs [0001] - [0007], [0019] - [0064], [0077] - [0088], [0104], [0105] * | 1,2, 5-10, 12-14<br>3,4,11 | INV.<br>G02B1/14<br>G02B1/11<br>G02B1/18<br>G06F1/16<br>H10K77/10 |
| X<br>Y | CN 114 096 894 A (APPLIED MATERIALS INC) 25 February 2022 (2022-02-25)<br>* paragraphs [0085] - [0091], [0161] - [0164]; claims 1-20; figures 1, 12 * | 1,2,5-7, 10,11<br>3,4,8,9, 11-14 | |
| Y | US 2017/156227 A1 (HEO JINNYOUNG [KR] ET AL) 1 June 2017 (2017-06-01)<br>* paragraph [0100]; table 1 * | 11 | |
| Y | KR 2015 0086426 A (LG HAUSYS LTD [KR]) 28 July 2015 (2015-07-28)<br>* paragraphs [0027], [0037], [0050] * | 3,4 | |
| Y | US 2010/165460 A1 (FURUI GEN [JP] ET AL) 1 July 2010 (2010-07-01)<br>* paragraphs [0168] - [0182] * | 8,9 | TECHNICAL FIELDS SEARCHED (IPC) |
| Y | US 2021/053330 A1 (KAKEYA FUMIAKI [JP] ET AL) 25 February 2021 (2021-02-25)<br>* paragraphs [0122] - [0132], [0166] - [0173]; figure 1 * | 8,9, 12-14 | G02B<br>B32B<br>G02F<br>H10K<br>G06F |
| A | US 2021/257582 A1 (KIM KYUNGTAE [KR] ET AL) 19 August 2021 (2021-08-19)<br>* the whole document * | 1-14 | |
| A | US 2023/045827 A1 (YOO GI NA [KR] ET AL) 16 February 2023 (2023-02-16)<br>* the whole document * | 1-14 | |

The present search report has been drawn up for all claims

1

| Place of search | Date of completion of the search | Examiner |
|---|---|---|
| Munich | 9 January 2025 | Knorn, Raphaela |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 20 0564

This annex lists the patent family members relating to the patent documents cited in the above-mentioned European search report.
The members are as contained in the European Patent Office EDP file on
The European Patent Office is in no way liable for these particulars which are merely given for the purpose of information.

09-01-2025

| Patent document cited in search report | Publication date | Patent family member(s) | Publication date |
|---|---|---|---|
| JP 2021004963 A | 14-01-2021 | NONE | |
| CN 114096894 A | 25-02-2022 | CN 114026627 A | 08-02-2022 |
| | | CN 114041181 A | 11-02-2022 |
| | | CN 114096894 A | 25-02-2022 |
| | | CN 114223025 A | 22-03-2022 |
| | | CN 118522220 A | 20-08-2024 |
| | | CN 118711458 A | 27-09-2024 |
| | | EP 3990954 A1 | 04-05-2022 |
| | | EP 3990955 A1 | 04-05-2022 |
| | | JP 7404406 B2 | 25-12-2023 |
| | | JP 7404407 B2 | 25-12-2023 |
| | | JP 7568660 B2 | 16-10-2024 |
| | | JP 7598888 B2 | 12-12-2024 |
| | | JP 2022538995 A | 07-09-2022 |
| | | JP 2022539325 A | 08-09-2022 |
| | | JP 2022539326 A | 08-09-2022 |
| | | JP 2022539687 A | 13-09-2022 |
| | | JP 2024050531 A | 10-04-2024 |
| | | JP 2024050532 A | 10-04-2024 |
| | | KR 20220024961 A | 03-03-2022 |
| | | KR 20220024963 A | 03-03-2022 |
| | | KR 20220024964 A | 03-03-2022 |
| | | KR 20220024969 A | 03-03-2022 |
| | | KR 20230173232 A | 26-12-2023 |
| | | KR 20230173748 A | 27-12-2023 |
| | | TW 202107241 A | 16-02-2021 |
| | | TW 202334782 A | 01-09-2023 |
| | | US 2020408956 A1 | 31-12-2020 |
| | | US 2020408957 A1 | 31-12-2020 |
| | | US 2020408961 A1 | 31-12-2020 |
| | | US 2020410208 A1 | 31-12-2020 |
| | | US 2024184153 A1 | 06-06-2024 |
| | | US 2024248339 A1 | 25-07-2024 |
| | | WO 2020263628 A1 | 30-12-2020 |
| | | WO 2020263631 A1 | 30-12-2020 |
| | | WO 2020263632 A1 | 30-12-2020 |
| | | WO 2020263633 A1 | 30-12-2020 |
| US 2017156227 A1 | 01-06-2017 | CN 106816098 A | 09-06-2017 |
| | | EP 3173856 A1 | 31-05-2017 |
| | | JP 2017100439 A | 08-06-2017 |
| | | KR 20170064103 A | 09-06-2017 |
| | | US 2017156227 A1 | 01-06-2017 |
| KR 20150086426 A | 28-07-2015 | NONE | |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 24 20 0564

This annex lists the patent family members relating to the patent documents cited in the above-mentioned European search report.
The members are as contained in the European Patent Office EDP file on
The European Patent Office is in no way liable for these particulars which are merely given for the purpose of information.

09-01-2025

| Patent document cited in search report | Publication date | Patent family member(s) | | Publication date |
|---|---|---|---|---|
| US 2010165460 A1 | 01-07-2010 | CN | 101506693 A | 12-08-2009 |
| | | JP | 5509594 B2 | 04-06-2014 |
| | | JP | WO2008020613 A1 | 07-01-2010 |
| | | KR | 20090047529 A | 12-05-2009 |
| | | TW | 200817716 A | 16-04-2008 |
| | | US | 2010165460 A1 | 01-07-2010 |
| | | WO | 2008020613 A1 | 21-02-2008 |
| US 2021053330 A1 | 25-02-2021 | CN | 111742246 A | 02-10-2020 |
| | | EP | 3757625 A1 | 30-12-2020 |
| | | JP | 7306370 B2 | 11-07-2023 |
| | | JP | WO2019163829 A1 | 04-02-2021 |
| | | US | 2021053330 A1 | 25-02-2021 |
| | | WO | 2019163829 A1 | 29-08-2019 |
| US 2021257582 A1 | 19-08-2021 | CN | 113270032 A | 17-08-2021 |
| | | EP | 3865973 A1 | 18-08-2021 |
| | | US | 2021257582 A1 | 19-08-2021 |
| US 2023045827 A1 | 16-02-2023 | CN | 115707315 A | 17-02-2023 |
| | | EP | 4134794 A1 | 15-02-2023 |
| | | KR | 20230025562 A | 22-02-2023 |
| | | US | 2023045827 A1 | 16-02-2023 |

EPO FORM P0459

For more details about this annex : see Official Journal of the European Patent Office, No. 12/82